# EUROPÄISCHE PATENTSCHRIFT

(11) **EP 1 566 648 B1**
(45) Veröffentlichungstag und Bekanntmachung des Hinweises auf die Patenterteilung: **15.08.2007**
(21) Anmeldenummer: 05001383.8
(22) Anmeldetag: 25.01.2005
(51) Int. Cl.: G01R 31/36

(54) **Verfahren zur Bestimmung mindestens einer Kenngrösse für den Zustand einer elektrochemischen Speicherbatterie und Überwachungseinrichtung**
Method for the determination of at least one characteristic for the state of an electrochemical storage battery and monitoring device
Procédé pour la détermination d'au moins une caractéristique pour l'état d'une batterie électrochimique et dispositif de surveillance

(30) Priorität: 18.02.2004 DE 102004007904
(43) Veröffentlichungstag der Anmeldung: 24.08.2005
(73) Patentinhaber: VB Autobatterie GmbH & Co. KGaA, 30419 Hannover (DE)
(72) Erfinder: Koch, Ingo, 31789 Hameln (DE); Meissner, Eberhard, 31515 Wunstorf (DE); Laig-Hoerstebrock, Helmut, 60320 Frankfurt (DE); Teutsch, Ursula, 65812 Bad Soden (DE)
(74) Vertreter: Gerstein, Hans Joachim

(56) Entgegenhaltungen:
- DE-A1- 10 103 848
- SAUER D U: "Modelling of local conditions in flooded lead/acid batteries in photovoltaic systems" JOURNAL OF POWER SOURCES, ELSEVIER SEQUOIA S.A. LAUSANNE, CH, Bd. 64, Nr. 1-2, 1997, Seiten 181-187, XP004075209 ISSN: 0378-7753

## Beschreibung

Die Erfindung betrifft ein Verfahren zur Bestimmung mindestens einer Kenngröße für den Zustand einer elektrochemischen Speicherbatterie mit dem Schritt:
a) Bestimmen des Ladungsdurchsatzes ΔQ der Speicherbatterie pro Zeitschritt Δt.

Die Erfindung betrifft weiterhin eine Überwachungseinrichtung für eine Speicherbatterie mit einer Einheit zur Bestimmung des Ladungsdurchsatzes der Speicherbatterie und mit Auswertemitteln.

Der Verschleiß von Speicherbatterien kann entweder bestimmt werden, indem aus der Betriebshistorie auf einen Zustand oder ein Verhalten der Speicherbatterie geschlossen wird. Es kann aber auch aus Messbefunden auf einen Zustand oder ein Verhalten der Speicherbatterie geschlossen werden.

Aus der DE 195 40 827 C1 ist ein Verfahren zur Alterungsbestimmung bekannt, bei dem ein Kennfeld der Batteriealterung in Abhängigkeit von der Entlademenge pro Entladezyklus als Batteriealterungseinflussgröße ausgewertet wird. In dem Verfahren werden die Einflussgrößen "Entladung" und "Entladetiefe" berücksichtigt, so dass die Entlademenge der Ladung zur Alterungsbestimmung herangezogen wird.

Weiterhin ist aus dem US-Patent 6,103,408 eine Alterungsuhr beschrieben, deren Frequenz als Funktion mindestens eines charakteristischen Wertes der Speicherbatterie variiert wird. Beispielsweise kann die Frequenz der Alterungsuhr mit ansteigender Elektrolyttemperatur und ansteigender Abweichung der Klemmenspannung von der Ruhespannung angehoben werden.

Zur Messung des Ladezustandes und der Bestimmung des Lastverhaltens von Speicherbatterien sind die verschiedensten Verfahren bekannt. So werden beispielsweise integrierende Messgeräte benutzt (Ah-Zähler), wobei der Ladestrom ggf. unter Bewertung mit einem festen Ladefaktor berücksichtigt wird. Da die nutzbare Kapazität einer Speicherbatterie stark von der Größe des Entladestroms und der Temperatur abhängig ist, kann auch mit solchen Verfahren keine zufriedenstellende Aussage über die der Batterie noch entnehmbare nutzbare Kapazität getroffen werden.

Aus der DE 22 42 510 C1 ist beispielsweise bekannt, bei einem Verfahren zur Messung des Ladezustandes den Ladestrom mit einem von der Temperatur und dem vom Ladezustand der Batterie selbst abhängigen Faktor zu bewerten.

In der DE 40 07 883 A1 ist ein Verfahren beschrieben, bei dem die Startfähigkeit einer Speicherbatterie durch Messung der Batterieklemmenspannung und der Batterietemperatur und Vergleich mit einer für den zu prüfenden Batterietyp geltenden Ladezustandskurvenschar ermittelt wird.

Der DE 195 43 874 A1 ist ein Berechnungsverfahren für die Entladungscharakteristik und Restkapazitätsmessung einer Speicherbatterie zu entnehmen, bei dem ebenfalls Strom, Spannung und Temperatur gemessen wird, wobei die Entladungscharakteristik durch eine mathematische Funktion mit gekrümmter Oberfläche angenähert wird.

In der DE 39 01 680 C1 ist ein Verfahren zur Überwachung der Kaltstartfähigkeit einer Starterbatterie beschrieben, bei dem die Starterbatterie zeitweise mit einem Widerstand belastet wird. Die am Widerstand abfallende Spannung wird gemessen und daraus im Vergleich mit Erfahrungswerten festgestellt, ob die Kaltstartfähigkeit der Starterbatterie noch ausreicht. Zur Belastung der Starterbatterie dient dabei der Anlassvorgang.

Weiterhin ist in der DE 43 39 568 A1 ein Verfahren zur Ermittlung des Ladezustandes einer Kraftfahrzeug-Starterbatterie zu entnehmen, bei dem Batteriestrom und Ruhespannung gemessen werden und aus diesen auf den Ladezustand geschlossen wird. Dabei wird zusätzlich auch die Batterietemperatur berücksichtigt. Die während verschiedener Zeiträume gemessenen Ladeströme werden miteinander verglichen und daraus eine Restkapazität ermittelt.

In der DE 198 47 648 A1 ist ein Verfahren zum Erlernen eines Zusammenhangs zwischen der Ruhespannung und dem Ladezustand einer Speicherbatterie zum Zweck der Abschätzung der Speicherfähigkeit beschrieben. Aus der Beziehung der Ruhespannungsdifferenz zur während der Belastungsphase umgesetzten Strommenge wird ein Maß für die Elektrolytkapazität des Elektrolyts der Speicherbatterie ermittelt. Dabei wird ausgenutzt, dass die Ruhespannung bei dem in der für die Praxis relevanten höheren Ladezustandsbereichen annähernd linear mit dem Ladezustand ansteigt.

Das Problem bei der Ermittlung des Zustandes einer elektrochemischen Speicherbatterie mit den vorbekannten Verfahren ist, dass insbesondere beim Entlade- und Ladetrieb wieder aufladbarer Speicherbatterien, aber auch bei der lastfreien Lagerung Verschleiß auftritt, wobei nicht alle relevanten Verschleißfaktoren berücksichtigt werden.

Im Falle eines Bleiakkumulators besteht der Elektrolyt aus verdünnter Schwefelsäure, d. h. eine Lösung von H₂SO₄ in Wasser. Typischerweise handelt es sich im vollständig geladenen Zustand um eine ca. 4 bis 5 molare Lösung. Bei der Entladereaktion wird entsprechend der Reaktionsgleichung
Positive Elektrode: PbO₂ + H₂SO₄ + 2H⁺+2e⁻→ PbSO₄+2H₂O
Negative Elektrode: Pb+H₂SO₄→ Pb+2H⁺+2e⁻
im Elektrolyten H₂SO₄ an beiden Elektroden verbraucht und zudem H₂O einer positiven Elektrode gebildet. Dadurch sinkt bei der Entladung die Konzentration und die spezifische Dichte des Elektrolyten, während sie bei der umgekehrt ablaufenden Ladereaktion wieder ansteigt.

Hat bei der Ladereaktion die gebildete Schwefelsäure die Möglichkeit einer Konvektion im Schwerefeld der Erde, so hat sie die Neigung in Schlieren zum Boden des Zellgefäßes der Zellen des Bleiakkumulators zu sinken. Dadurch liegt dann im unteren Bereich des jeweiligen Zellgefäßes ein Elektrolyt mit höherer Konzentration vor, als im oberen Bereich des Zellgefäßes. Dieser Zustand wird im Falle des Bleiakkumulators als Säureschichtung bezeichnet.

Da sowohl die Lade- / Entladereaktion als auch die parasitären Reaktionen, wie z. B. Gasentwicklung, Korrosion etc. im Allgemeinen von der Elektrolytkonzentration beeinflusst werden, führt eine Säureschichtung zu einer Verungleichmäßigung des Zustandes der Zelle.

DE 109 03 848 A1 offenbart Verfahren zur Ermittlung des Alterungszustandes einer Batterie unter anderem in Abhängigkeit von der Säureschichtung unter Verwendung von Fuzzy-Algorithmen.

Mit den bekannten Verfahren werden allerdings nur sich monoton entwickelnde Alterungskenngrößen bewertet und der Effekt der Schichtung der Elektrolytkonzentration nicht berücksichtigt, die zunehmen und in bestimmten Situationen auch wieder abnehmen kann.

Aufgabe der Erfindung ist es daher, ein verbessertes Verfahren zur Bestimmung mindestens einer Kenngröße für den Zustand einer elektrochemischen Speicherbatterie zu schaffen, die den Effekt der Elektrolytschichtung mit berücksichtigt.

Die Aufgabe wird mit dem gattungsgemäßen Verfahren erfindungsgemäß gelöst durch die weiteren Schritte von:
b) Ermitteln einer ersten Kennzahl KS zur Beschreibung der Schichtung der Elektrolytkonzentration in der Speicherbatterie ausgehend von einem definierten Anfangswert KSₒ für eine neuwertige Speicherbatterie und einer zweiten Kennzahl KL zur Beschreibung der Schichtung des Ladezustands SOC in der Speicherbatterie ausgehend von einem definierten Anfangswert KL₀ für eine neuwertige Speicherbatterie im Betrieb der Speicherbatterie, wobei
c) für jeden Zeitschritt Δt, aus dem aktuellen Zustand der Speicherbatterie, der durch den Ladezustand der Elektroden, die Elektrolytkonzentration in der Speicherbatterie und die erste und zweite Kennzahl KS, KL gekennzeichnet ist, die erste Kennzahl KS und die zweite Kennzahl KL in Abhängigkeit von dem Ladungsdurchsatz ΔQ angepasst wird und mindestens eine Kenngröße aus der ersten und zweiten Kennzahl KS, KL bestimmt wird.

Das Verfahren ist insbesondere geeignet für Bleiakkumulatoren mit flüssigen Elektrolyten, ohne dass es jedoch auf solche Typen von Speicherbatterien beschränkt wäre.

Durch die Definition einer ersten und zweiten Kennzahl ist es nunmehr möglich, die Leistungsfähigkeit einer elektrochemischen Speicherbatterie, insbesondere die Speicherfähigkeit, den Ladezustand, das Spannungsverhalten bei Belastung mit Strömen, das Spannungsverhalten im lastfreien Zustand (innere Umladung) oder den Verschleißgrad vorherzusagen, indem lediglich der Ladungsdurchsatz für definierte Zeitschritte bestimmt und bewertet wird. Die erhaltenen ersten und zweiten Kennzahlen KS und KL werden hierzu genutzt.

Hierzu kann einerseits mindestens eine der erhaltenen Kennzahlen verwendet werden, um eine Maßnahme auszulösen, z. B. einen Wartungshinweis oder Austauschhinweis, die Regelung einer Ladeeinrichtung oder Pumpe oder Temperiereinrichtung. Es kann auch auf bekannt Verfahren zurückgegriffen werden, die mit Hilfe der ersten und zweiten Kennzahlen KS und KL nunmehr um eine Maßzahl für das Ausmaß der Elektrolytschichtung erweitert werden können.

Die Erhöhung der ersten Kennzahl bei Nettoladung pro Zeitschritt und die Verminderung der ersten Kennzahl und gleichzeitige Erhöhung der zweiten Kennzahl bei Nettoentladung ist dabei geeignet, den Verschleiß der Speicherbatterie über die Lebensdauer zu beschreiben.

Vorzugsweise werden mindestens zwei der folgenden Betriebsphasen bei der Anpassung der ersten und zweiten Kennzahl unterschieden:
a) STROMLOS, wenn der Betrag des Ladungsdurchsatzes pro Zeitschritt kleiner als ein Schwellwert ist;
b) ENTLADUNG, wenn der Ladungsdurchsatz pro Zeitschritt negativ und betragsmäßig größer als der Schwellwert ist;
c) LADUNG, wenn der Ladungsdurchsatz pro Zeitschritt positiv und betragsmäßig größer als der Schwellwert und keine ÜBERLADUNG vorliegt;
d) ÜBERLADUNG, wenn der Ladungsdurchsatz pro Zeitschritt positiv und betragsmäßig größer als der Schwellwert ist und gleichzeitig die erste Kennzahl bezogen auf den Wertebereich in der nähe des Anfangswertes liegt, oder wenn aus dem Ladungsdurchsatz und dem Ladezustand der Speicherbatterie eine Gasentwicklung erkannt wird, die einen definierten Gasungs-Schwellwert überschreitet.

Hierdurch kann dann der unterschiedliche Einfluss der genannten Betriebsphasen auf die Bildung und Rückbildung von Elektrolytschichtung in Verbindung mit sonstigen Verschleißfaktoren durch Anpassung der Kennzahlen berücksichtigt werden.

Der Schwellwert wird vorzugsweise kleiner als der 20-stündige Strom und besonders bevorzugt kleiner als der 100-stündige Strom der Speicherbatterie festgelegt.

In Abhängigkeit von den erkannten Betriebszuständen werden die ersten und zweiten Kennzahlen vorzugsweise wie folgt angepasst:

Im Betriebszustand LADUNG wird die erste Kennzahl erhöht. Die zweite Kennzahl wird dann erhöht, wenn die erste Kennzahl bezogen auf ihren Wertebereich nicht nahe dem Anfangswert ist und die Summe des Wertes für den Ladezustand und der zweiten Kennzahl bezogen auf den Wertebereich einen nicht zu hohen Wert aufweist. Die zweite Kennzahl wird hingegen erniedrigt, wenn die erste Kennzahl bezogen auf Ihren Wertebereich nicht nahe dem Anfangswert ist und die Summe des Wertes für den Ladezustand und der zweiten Kennzahl bezogen auf Ihren Wertebereich einen hohen Wert aufweist.

Damit wird berücksichtigt, dass bei Ladung mit bereits eingetretenen Elektrolytschichtung im fortgeschrittenen Stadium auch eine Schichtung des Ladezustandes auftritt. Die Ladezustandsschichtung nimmt allerdings bei Ladung dann wieder ab, wenn der Ladezustandswert und/oder die zweite Kennzahl für die Schichtung des Ladezustandes relativ groß ist.

Im Betriebszustand ÜBERLADUNG wird die erste Kennzahl vermindert. Die zweite Kennzahl wird dann vermindert, wenn der Wert der ersten Kennzahl im Bereich des Anfangswertes ist, d. h. noch kaum Elektrolytschichtung vorhanden ist.

Durch die bei ÜBERLADUNG auftretenden Gasentwicklung wird das Elektrolyt nämlich verwirbelt, so dass die Elektrolytschichtung reduziert wird.

Im Betriebszustand ENTLADUNG wird die zweite Kennzahl für die Ladezustandsschichtung erhöht, wenn die erste Kennzahl bezogen auf ihren Wertebereich einen sehr hohen Wert aufweist, d. h., wenn die Elektrolytschichtung relativ groß ist. Erst dann tritt nämlich bei Entladung eine Ladezustandsschichtung auf.

Im Betriebszustand ENTLADUNG wird die erste Kennzahl dann erhöht, wenn die zweite Kennzahl bezogen auf ihren Wertebereich nicht nahe dem Anfangswert ist und der Wert des Ladezustandes vermindert um den Wert der zweiten Kennzahl bezogen auf den Wertebereich klein ist. Dies basiert auf der Erkenntnis, dass die Elektrolytschichtung bei Entladung zunimmt, wenn der aktuelle Ladezustandswert niedriger als der bisher niedrigste Ladezustandswert seit dem letzten Erreichen eines Zustandes der weitgehenden Volladung oder eines Zustandes ist, in dem die erste Kennzahl bezogen auf ihren Maximalwert einen kleinen Wert hat.

Im Betriebszustand ENTLADUNG wird die erste Kennzahl dann erniedrigt, wenn die zweite Kennzahl bezogen auf ihren Wertebereich einen erheblichen Wert aufweist und der Wert des Ladezustandes vermindert um den Wert der zweiten Kennzahl bezogen auf den Wertebereich einen Mindestwertebereich überschreitet und nicht zu klein ist. Damit wird berücksichtigt, dass die Elektrolytschichtung bei Entladung bei erheblicher Ladezustandsschichtung oder einem großen Ladezustandswert wieder abnimmt.

Im Betriebszustand STROMLOS, bei dem die Speicherbatterie im Ruhezustand ist, wird die erste Kennzahl vermindert und die zweite Kennzahl erhöht, d. h., dass im Ruhezustand die Elektrolytschichtung automatisch abnimmt, die Ladezustandsschichtung jedoch zunimmt.

Der Zeitschritt At sollte maximal in der Größenordnung einer für den Speicherbatterietyp charakteristischen Zeitkonstanten für den Ausgleich von Säuredichteverteilungen senkrecht zu den Elektroden liegen, vorzugsweise in einem Bereich von einer Sekunde bis 30 Minuten, d. h, dass der Zeitschritt At in Abhängigkeit davon gewählt wird, wie schnell eine Elektrolytschichtung von der Speicherbatterie im normalen Betrieb und normalen Betriebszustand wieder abgebaut wird.

Die Zeitschritte At sollten zudem so gewählt sein, dass während der jeweiligen Zeitschritte At der Strom der Speicherbatterie weitgehend konstant ist.

Vorzugsweise wird ein Minimalwert und/oder ein Maximalwert für die erste Kennzahl KS bzw. die zweite Kennzahl KL festgelegt. Durch Beschränkung der Werte für die ersten und zweiten Kennzahlen auf die jeweils festgelegten Minimal- und/oder Maximalwerte wird ein Zustand der Speicherbatterie ohne Schichtung der Elektrolytkonzentration, mit maximaler Schichtung der Elektrolytkonzentration, ohne Ladezustandsschichtung und mit maximaler Ladezustandsschichtung berücksichtigt. Der Minimalwert für die erste Kennzahl steht hierbei für einen nie zu unterschreitenden Wert, wenn keine Schichtung der Elektrolytkonzentration vorliegt. Der maximale Wert für die erste Kennzahl KS ist ein nie zu überschreitender Wert bei maximaler Säureschichtung und stellt eine Kenngröße für die Speicherbatterie bei einer maximal ausgeprägten Schichtung der Elektrolytkonzentration dar. Der Minimalwert für die zweite Kennzahl KL ist ein nie zu unterschreitender Wert, wenn keine Ladezustandsschichtung vorliegt. Der Maximalwert für die zweite Kennzahl KL ist ein nie zu überschreitender Wert bei maximaler Ladezustandsschichtung und stellt eine Kenngröße für die Speicherbatterie bei einer maximal ausgeprägten Schichtung des Ladezustandes der Elektroden dar.

Vorzugsweise ist der Minimalwert der ersten Kennzahl KS der definierte Anfangswert der ersten Kennzahl KS₀ für eine neuwertige Speicherbatterie und beträgt vorzugsweise Null. Entsprechendes gilt für den Minimalwert der zweiten Kennzahl KS.

Die Erhöhung der ersten Kennzahl KS für jeden Zeitschritt Δt, in dem eine Ladung erkannt wurde, ist vorzugsweise proportional oder überproportional mit dem Ladungsdurchsatz ΔQ in diesem Zeitschritt. D. h., je höher der Ladungsdurchsatz Q in dem Zeitschritt Δt ist, um so höher ist die Erhöhung. Entsprechend kann auch die Erhöhung der ersten Kennzahl KS proportional oder überproportional mit der Ladungsdurchsatzrate ΔQ/Δt mit dem Zeitschritt Δt sein.

Weiter ist es vorteilhaft, wenn die Erhöhung der ersten Kennzahl KS für jeden Zeitschritt, in dem eine Ladung erkannt wurde, um so kleiner ist, je höher der Wert der ersten Kennzahl KS ist. Hierdurch wird der Effekt berücksichtigt, dass ab einer bestimmten Schichtung der Elektrolytkonzentration eine Sättigung erreicht wird, bei der eine weitere Schichtung der Elektrolytkonzentration langsamer erfolgt.

Weiter ist es vorteilhaft, wenn die erste Kennzahl KS bei einem Ladungsdurchsatz ΔQ in einem Zeitschritt At, der unterhalb eines festgelegten unteren Grenzwertes Qₘᵢₙ liegt, nicht erhöht wird. Hierdurch wird berücksichtigt, dass Verschleiß und Schichtung der Elektrolytkonzentration bei Ladungen unterhalb des für den Speicherbatterietyp charakteristischen unteren Grenzwertes für den Ladungsdurchsatz pro Zeitschritt nicht zunehmen. In entsprechender Weise kann auch der Erhöhungswert auf die Erhöhung bei einem oberen Grenzwert für den Ladungsdurchsatz pro Zeitschritt begrenzt werden. Die Schichtung der Elektrolytkonzentration nimmt nämlich bei Ladungsdurchsätzen pro Zeitschritt oberhalb des oberen Grenzwertes nicht weiter zu.

Natürlich völlig gleichwertig ist es, wenn die ersten und zweiten Kennzahlen ihren Maximalwert im Ausgangszustand ohne Elektrolytschichtung bzw. ohne Ladezustandsschichtung annehmen und dann bei zunehmenden Verschleiß vermindert werden, bis sie bei maximaler Schichtung einen Minimalwert annehmen.

Die erste Kennzahl KS kann vorzugsweise zur Vorhersage der beschleunigten Änderung der Ruhespannung infolge innerer Umladung verwendet werden. Hierzu ist es vorteilhaft, die Steilheit S einer Kennlinie der Ruhespannung über den Ladungsdurchsatz zur Vorhersage der entladbaren Ladungsmenge, der Spannungsänderung bei einer Änderung der elektrischen Last oder der absoluten Spannungslage bei einer aufgenommenen elektrischen Last aus einem vorgegebenen oder erlernten Zusammenhang zwischen der Steilheit und der ersten Kennzahl zu berechnen. Ebenso kann die Änderung der Ruhespannung als Funktion der Zeit aufgrund innerer Umladungsprozesse zwischen Bereichen der Speicherbatterie mit unterschiedlichen Säurekonzentrationen mit einem vorgegebenen oder erlernten temperaturabhängigen Zusammenhang der Ruhespannung und der ersten Kennzahl vorhergesagt werden.

Weiterhin kann eine dritte Kennzahl KW vorgesehen werden, die im Betriebszustand ÜBERLADUNG erhöht wird. Diese dritte Kennzahl KW dient als Maß für den Verschleiß der Speicherbatterie und kann ausgehend von einem Anfangswert bei jeder Überladung nur ansteigen und wird nie vermindert, d. h., dass Verschleißprozesse durch Überladung als unumkehrbar angesehen werden.

Es kann auch auf bekannte Verfahren zurückgegriffen werden, die mit Hilfe der ersten und zweiten Kennzahl KS, KL nunmehr um eine Maßzahl für das Ausmaß der Schichtung erweitert werden können. Die Erhöhung der ersten Kennzahl bei Nettoladung pro Zeitschritt und die Verminderung der ersten Kennzahl und die Erhöhung der zweiten Kennzahl bei Nettoentladung ist dabei geeignet, Veränderungen des Zustandes und des elektrischen Verhaltens sowie den Verschleiß der Speicherbatterie über die Lebensdauer zu beschreiben.

Die erhaltenen ersten und zweiten Kennzahlen KS, KL werden verwendet um eine Maßnahme auszulösen, z. B. einen Wartungshinweis oder Austauschhinweis, die Regelung einer Ladeeinrichtung oder Pumpe oder Temperiereinrichtung. Die Kennzahlen können auch für Vorhersagen des Verhaltens des Energiespeichers verwendet werden, insbesondere zur Vorhersage der Speicherfähigkeit, des Ladezustandes, des Spannungsverhaltens bei Belastung mit Strömen, des Spannungsverhaltens im lastfreien Zustand (innere Umladung) oder des Verschleißgrades. Dabei kann auf bekannte Verfahren zurückgegriffen werden, die mit Hilfe der ersten und zweiten Kennzahlen KS, KL nunmehr um eine Maßzahl für das Ausmaß der Schichtung erweitert werden können.

Die Erfindung wird nachfolgend anhand der beigefügten Zeichnungen näher erläutert.
Es zeigen:
- Figur 1 -: ein Flussdiagramm des erfindungsgemäßen Verfahrens zur Bestimmung mindestens einer Kenngröße für die Leistungsfähigkeit einer elektrochemischen Speicherbatterie;
- Figur 2 -: ein Flussdiagramm des erfindungsgemäßen Verfahrens im Betriebszustand STROMLOS;
- Figur 3 -: ein Flussdiagramm des erfindungsgemäßen Verfahrens im Betriebszustand ENTLADUNG;
- Figur 4 -: ein Flussdiagramm des erfindungsgemäßen Verfahrens im Betriebszustand LADUNG;
- Figur 5 -: ein Flussdiagramm des erfindungsgemäßen Verfahrens im Betriebszustand ÜBERLADUNG bzw. Gasung;
- Figur 6 -: beispielhaftes Diagramm für die Entwicklung der ersten und zweiten Kennzahl während eines langen Betriebszustandes STROMLOS;
- Figur 7 -: beispielhaftes Diagramm für die Entwicklung der offenen Batteriespannung während einer langen Phase des Betriebszustandes "STROMLOS".

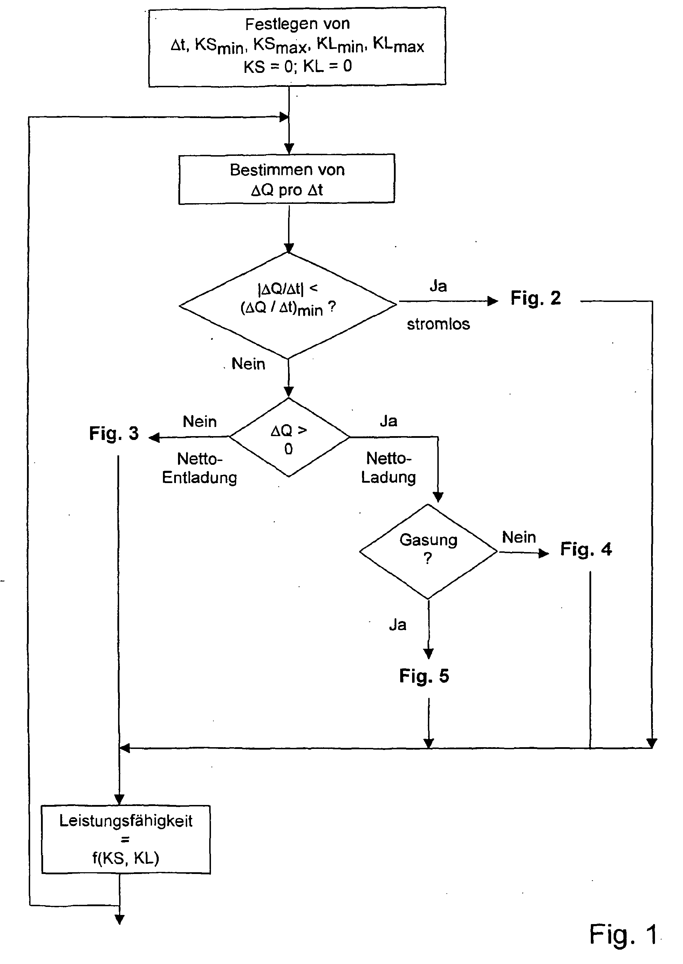

Die Figur 1 lässt ein Flussdiagramm des Verfahrens zur Bestimmung einer ersten Kennzahl KS und einer zweiten Kennzahl KL zur Bewertung der Leistungsfähigkeit einer elektrochemischen Speicherbatterie erkennen.

In einem ersten Schritt wird ein Zeitschritt Δt für den Speicherbatterietyp festgelegt. Die Größenordnung des Zeitschritts Δt liegt im Wertebereich der typischen Zeitkonstante für den Ausgleich von Säuredichte senkrecht zu den Elektroden der Speicherbatterie und beträgt einige 10 Sekunden bis zu 30 Minuten. Es ist vorteilhaft, wenngleich nicht dargestellt, wenn der Zeitschritt Δt im Laufe des Verfahrens an die jeweils vorherrschende Temperatur der Speicherbatterie angepasst wird, indem der Zeitschritt Δt bei ansteigenden Temperaturen verkürzt wird.

Weiterhin wird für den Speicherbatterietyp ein Minimalwert KSₘᵢₙ für die erste Kennzahl KS, ein Maximalwert KSₘₐₓ für die erste Kennzahl KS, ein Minimalwert KLₘᵢₙ für die zweite Kennzahl KL und ein Maximalwert KLₘₐₓ für die zweite Kennzahl KL festgelegt. Die Minimalwerte KSₘᵢₙ und KLₘᵢₙ werden dabei vorzugsweise auf Null gesetzt, um die Kennzahlen KS, KL auf den entsprechenden Wert für die Kennzahlen KS, KL eines neuwertigen elektrochemischen Energiespeichers zu beschränken. Der festgelegte Maximalwert KSₘₐₓ für die erste Kennzahl wird auf einen maximalen Wert der Kennzahl KS für eine maximal ausgeprägte Schichtung der Elektrolytkonzentration des elektrochemischen Energiespeichers gesetzt. Der Maximalwert KLₘₐₓ für die zweite Kennzahl KL wird auf einen maximalen Wert für die zweite Kennzahl KL gesetzt, bei dem eine maximal ausgeprägte Schichtung des Ladezustandes der Elektroden des elektrochemischen Energiespeichers vorliegt.

Die Minimal- und Maximalwerte können beispielsweise anhand von Versuchen an gleichartigen Speicherbatterien ermittelt und dann für den Speicherbatterietyp vorgegeben werden.

Vor der ersten Inbetriebnahme der (noch keine Schichtung der Elektrolytkonzentration aufweisenden) Speicherbatterie wird die erste Kennzahl KS und die zweite Kennzahl KL auf ihre Anfangswerte KS₀ und KL₀, vorzugsweise auf den Wert Null gesetzt.

Während des Betriebes und der Lebensdauer der Speicherbatterie wird vorzugsweise fortlaufend, ggf. aber auch in Intervallen der Ladungsdurchsatz ΔQ der Speicherbatterie pro festgelegtem Zeitschritt Δt beispielsweise durch Strommessung, Schätzung, Modellierung o. ä. bestimmt. Gegebenenfalls werden obere und untere Schwellwerte (ΔQ/Δt)ₘᵢₙ und (ΔQ/Δt)ₘₐₓ berücksichtigt, die nicht überschritten werden dürfen. Aus dem Ladungsdurchsatz ΔQ pro Zeitschritt Δt wird die Ladedurchsatzrate ΔQ/Δt berechnet. Die Berücksichtigung von Schwellwerten (ΔQ/Δt)ₘᵢₙ und (ΔQ/Δt)ₘₐₓ kann auch anhand der Ladedurchsatzrate ΔQ/Δt erfolgen.

In einem nächsten Schritt wird überprüft, ob der Betrag der Ladungsdurchsatzrate kleiner als ein definierter Grenzwert für die Ladungsdurchsatzrate (ΔQ/Δt)ₘᵢₙ ist. Der Grenzwert kann beispielsweise als 1000-stündiger Strom festgelegt werden. Sofern die Ladungsdurchsatzrate ΔQ/Δt kleiner als der Grenzwert ist, wird ein Ruhezustand erkannt. Optional kann der Ruhezustand auch temperaturabhängig bewertet werden, wobei bei niedrigen Temperaturen der Grenzwert für die Ladungsdurchsatzrate (ΔQ, Δt)ₘᵢₙ vorzugsweise größer festgelegt wird, als bei höheren Temperaturen.

Sofern kein Ruhezustand erkannt wurde, wird geprüft, ob der Ladungsdurchsatz ΔQ größer Null ist. Sofern der Ladungsdurchsatz größer Null ist, wird ein normaler elektrischer Betrieb mit Nettoladung erkannt, d. h. der Betriebszustand LADUNG.

Anschließend muss überprüft werden, ob eine ÜBERLADUNG vorliegt, d. h. ob das Kriterium der Gasung gegeben ist. Dies kann beispielsweise durch Bewertung von Ladespannung, Temperatur und Dauer der Ladung und ggf. auch des Ladestroms erfolgen.

In Abhängigkeit von den Betriebszuständen STROMLOS, ENTLADUNG, ÜBERLADUNG und LADUNG wird die erste und zweite Kennzahl KS und KL angepasst und die Leistungsfähigkeit der Speicherbatterie als Funktion hieraus bestimmt.

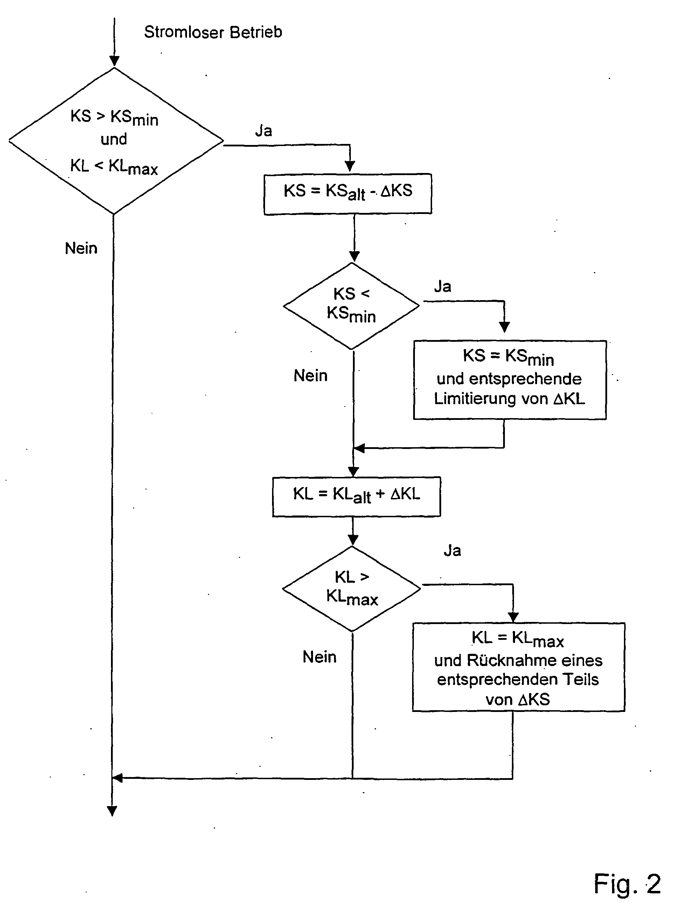

Die Figur 2 lässt das Verfahren der Anpassung der ersten und zweiten Kennzahlen KS, KL im Betriebszustand STROMLOS erkennen. Eine Änderung der ersten und zweiten Kennzahl KS und KL erfolgt nur dann, wenn die erste Kennzahl KS größer als der Minimalwert KSₘᵢₙ und die zweite Kennzahl KL kleiner als der Maximalwert KLₘₐₓ ist.

Für den Fall, dass der Ruhezustand erkannt wurde, wird, wie in der Figur 2 skizziert ist, der Wert der aktuellen ersten Kennzahl KSₐₗₜ um einen Wert ΔKS vermindert, wobei die resultierende erste Kennzahl KS auf den definierten Minimalwert KSₘᵢₙ begrenzt wird. Weiterhin wird die zweite Kennzahl KL um den Wert ΔKL erhöht und die zweite Kennzahl KL ebenfalls auf den definierten Maximalwert KLₘₐₓ begrenzt, der bei maximaler Ladezustandsschichtung nie überschritten wird.

Die Verminderung ΔKS der ersten Kennzahl KS und die Erhöhung ΔKL der zweiten Kennzahl KL pro Zeiteinheit Δt durch Umladung während der Ruhephase ist umso stärker, je länger die Zeiteinheit Δt, je größer der Wert der ersten Kennzahl KS und je höher die Temperatur T sind.

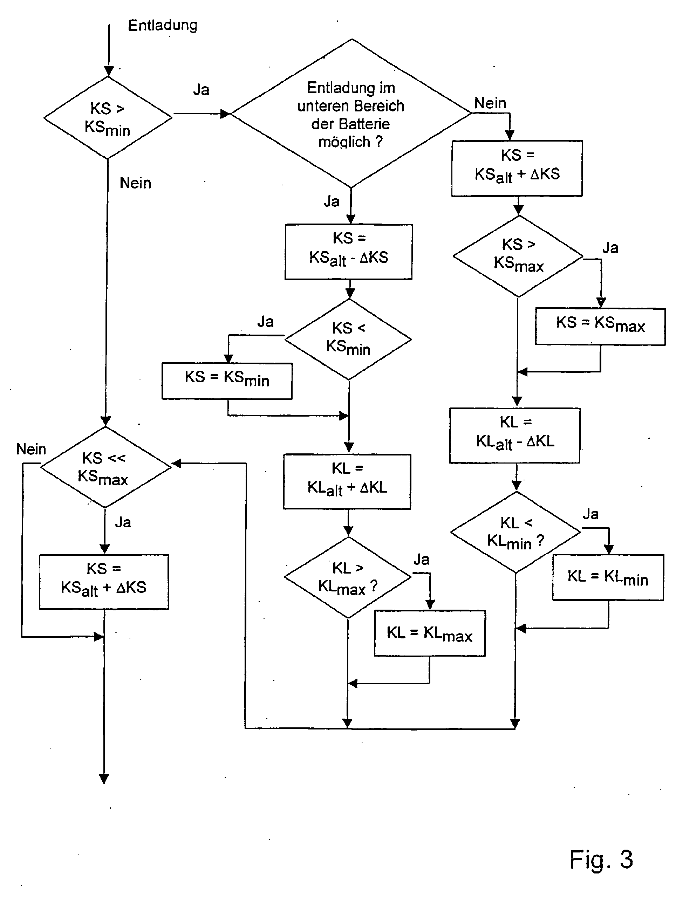

Die Figur 3 lässt das Verfahren zur Anpassung der ersten und zweiten Kennzahl KS und KL im Betriebszustand ENTLADUNG erkennen. Sofern die erste Kennzahl KS kleiner oder gleich dem festgelegten Minimalwert KSₘᵢₙ ist und wesentlich kleiner als der festgelegte Maximalwert KSₘₐₓ ist, wird lediglich die erste Kennzahl KS im einem Zeitschritt Δt um den Wert ΔKS erhöht. Die zweite Kennzahl KL bleibt dann unverändert.

Für den Fall, dass die erste Kennzahl KS größer als der Minimalwert KSₘᵢₙ ist, wird überprüft, ob eine Entladung im unteren Bereich der Batterie noch möglich ist.

Für den Normalfall, dass die Speicherbatterie auch im unteren Bereich noch weiter entladen werden kann, wird die erste Kennzahl KS um den Wert ΔKS vermindert und dabei auf den festgelegten Minimalwert KSₘᵢₙ nach unten hin begrenzt. Weiterhin wird die zweite Kennzahl KL um den Wert ΔKL erhöht. Die zweite Kennzahl KL wird dabei auf den definierten Maximalwert KLₘₐₓ begrenzt, der bei maximaler Ladezustandsschichtung nie überschritten wird.

Für den Fall, dass keine Entladung im unteren Bereich der Speicherbatterie mehr möglich ist, wird die erste Kennzahl KS um den Wert ΔKS erhöht und die erste Kennzahl KS dabei auf den Maximalwert KSₘₐₓ begrenzt. In diesem Falle wird bei Entladung eine Zunahme der Elektrolytkonzentrationsschichtung angenommen. Der Wert für die zweite Kennzahl KL wird hingegen um den Wert ΔKL vermindert, wobei die resultierende zweite Kennzahl KL auf den definierten Minimalwert KLₘᵢₙ begrenzt wird.

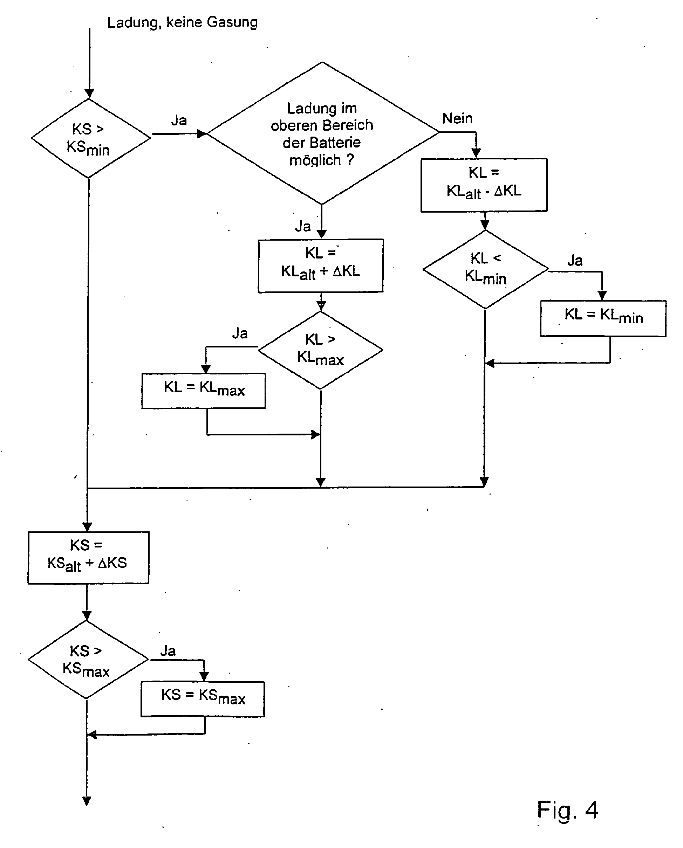

Die Figur 4 lässt das Verfahren zur Anpassung der ersten und zweiten Kennzahlen KS, KL für den Fall der Ladung erkennen, wenn keine Überladung bzw. Gasung vorliegt. Für den Fall, dass die erste Kennzahl KS kleiner oder gleich dem festgelegten Minimalwert KSₘᵢₙ ist, wird lediglich die erste Kennzahl für die Elektrolytschichtung um den Wert ΔKS erhöht. Dabei wird die erste Kennzahl KS auf den festgelegten Maximalwert KSₘₐₓ begrenzt.

Anderenfalls wird überprüft, ob eine Ladung im oberen Bereich der Batterie noch möglich ist. Sofern dies der Fall ist und die Speicherbatterie somit ohne Gefahr der Überladung weiter geladen werden kann, wird die zweite Kennzahl KL um den Wert ΔKL erhöht. Dabei wird die zweite Kennzahl KL auf den festgelegten Maximalwert KLₘₐₓ begrenzt, der bei maximaler Ladezustandsschichtung nie überschritten wird. Zudem wird auch die erste Kennzahl KS um den Wert ΔKS erhöht. Auch die resultierende erste Kennzahl KS wird auf definierten Maximalwert KSₘₐₓ begrenzt. Für diesen Normalfall der Ladung wird somit eine Verstärkung der Elektrolytkonzentrationsschichtung und der Ladezustandsschichtung der Elektroden angenommen.

Für den Fall, dass keine Ladung im oberen Bereich der Speicherbatterie mehr möglich ist, nimmt im Betriebszustand LADUNG die Ladezustandsschichtung wieder ab. Daher wird die zweite Kennzahl KL um den Wert ΔKL vermindert und die resultierende zweite Kennzahl KL auf den definierten Minimalwert KLₘᵢₙ begrenzt. Die erste Kennzahl KS wird hingegen um den Wert ΔKS erhöht und auf den festgelegten Maximalwert KSₘₐₓ begrenzt.

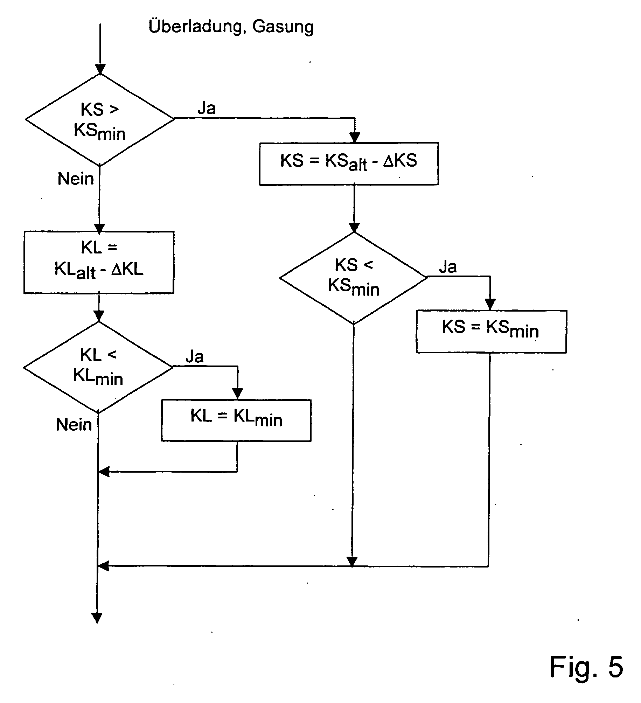

Die Figur 5 lässt das Verfahren im Betriebszustand ÜBERLADUNG bzw. Gasung erkennen. Für den Falls, dass bereits eine Schichtung der Elektrolytkonzentration vorliegt, d. h., dass die erste Kennzahl KS größer als der festgelegte Minimalwert KSₘᵢₙ ist, wird die erste Kennzahl KS um den Wert ΔKS vermindert. Im Falle der Überladung wird die Elektrolytschichtung somit zunächst ausgeglichen. Dabei wird die erste Kennzahl KS wiederum auf den festgelegten Minimalwert KSₘᵢₙ begrenzt.

Für den Fall, dass keine nennenswerte Schichtung der Elektrolytkonzentration mehr vorliegt, d. h., dass die erste Kennzahl KS dem festgelegten Minimalwert KSₘᵢₙ nahe ist, wird die Ladezustandsschichtung durch Reduzieren der zweiten Kennzahl KL um den Wert ΔKL ausgeglichen. Wiederum wird die zweite Kennzahl KL auf den Minimalwert KLₘᵢₙ begrenzt. Das Verfahren berücksichtigt somit den Effekt, dass eine Überladung erst die Schichtung der Elektrolytkonzentration und danach die Schichtung des Ladezustands ausgleicht.

Grundsätzlich sollten die Verminderung ΔKS der ersten Kennzahl KS pro Zeitschritt Δt umso stärker erfolgen, je größer der Ladungsdurchsatz ΔQ und je größer die Änderungsrate ΔQ/Δt und je größer der Wert der ersten Kennzahl KS und je höher die Temperatur t sind.

Ebenso sollen die Verminderung ΔKL der zweiten Kennzahl KL pro Zeitschritt Δt umso stärker erfolgen, je größer der Ladungsdurchsatz ΔQ und je größer die Änderungsrate ΔQ/Δt, und je größer der Wert der zweiten Kennzahl KL und je höher die Temperatur T sind.

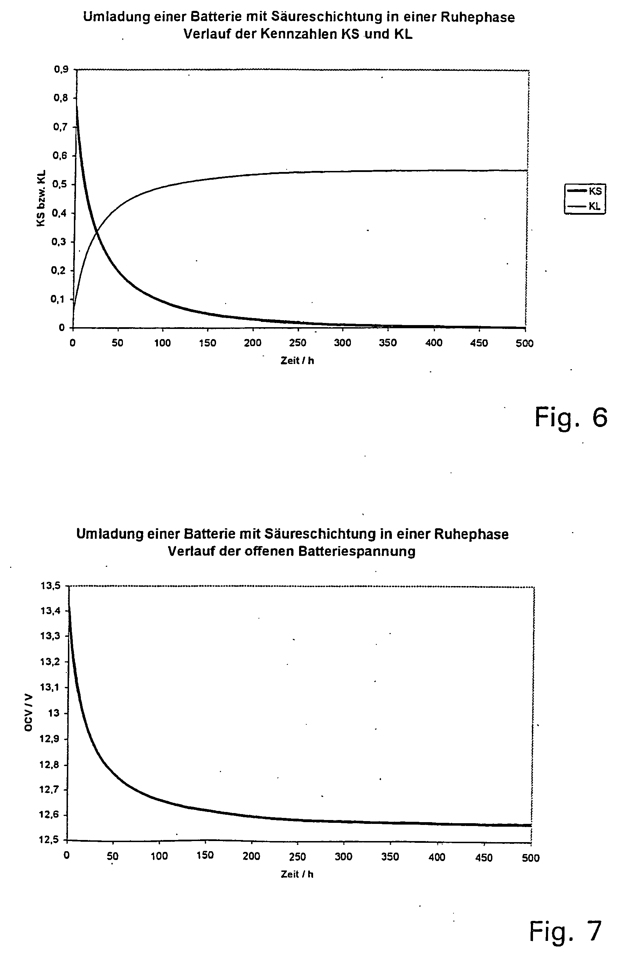

Die Figuren 6 und 7 zeigen beispielhafte Diagramme für die Entwicklung der ersten und zweiten Kennzahl KS und KL sowie der offenen Batteriespannung während einer langen stromlosen Phase. Zu Beginn dieser Phase im Betriebszustand STROMLOS liegt eine deutliche Schichtung der Elektrolytkonzentration in der Speicherbatterie vor, die für die hohe Ruhespannung OCV verantwortlich ist. Durch innere Umladung wird die erste Kennzahl KS abgesenkt, während die zweite Kennzahl KL ansteigt. D. h., dass die Schichtung der Elektrolytkonzentration abnimmt, während die Schichtung des Ladezustands in den Elektroden zunimmt. Die Ruhespannung OCV fällt dementsprechend.

Neben den ersten und zweiten Kennzahlen kann auch noch eine weitere dritte Kennzahl KW definiert werden, die im Betriebszustand ÜBERLADUNG erhöht wird. Die dritte Kennzahl KW dient als ein Maß für den Verschleiß der Speicherbatterie und kann ausgehend von einem Anfangswert KWₘᵢₙ, vorzugsweise KWₘᵢₙ gleich Null, nur ansteigen und wird nie vermindert.

Nachfolgend werden Beispiele für die Nutzung der erhaltenen ersten, zweiten und dritten Kennzahl KS, KL und KW angegeben.
1) Die erhaltenen Kennzahlen KS, KL und KW können direkt verwendet werden, um eine Maßnahme auszulösen, z. B. einen Wartungshinweis oder Austauschhinweis, die Regelung einer Ladeeinrichtung oder Pumpe oder Temperiereinrichtung, etc.
   1a) Der Vergleich einer der Kennzahlen KS, KL und KW mit entsprechenden Schwellwerten kann verwendet werden, um den Betreiber der mit der Speicherbatterie verbundenen Einheit aufzufordern, eine Wartung durchzuführen. Zur Verminderung der ersten und zweiten Kennzahl KS und KL ist z. B. eine gezielte (Über-) Ladung sinnvoll. Aus einem ansteigenden Wert der dritten Kennzahl KW kann eine Aufforderung zum Nachfüllen von Wasser zum Elektrolyten abgeleitet werden.
   1b) Der Vergleich einer der Kennzahlen KS, KL und KW mit entsprechenden Schwellwerten kann verwendet werden, um den Betreiber zum Austausch der Speicherbatterie aufzufordern. Dies ist sinnvoll, wenn eine Wartung im Sinne von Punkt 1a) nicht möglich oder gewollt ist, oder bereits vergeblich oder wiederholt durchgeführt worden ist. Wenn z. B. längere Zeit eine Ladezustandsschichtung vorgelegen hat, ist deren Aufhebung unter Umständen nicht mehr möglich oder ein Austausch die kostengünstigere Alternative.
   1c) Der Wert der ersten und zweiten Kennzahl KS oder KL kann verwendet werden, um das Laderegime der Speicherbatterie zu regeln. Da die Schichtung der Elektrolytkonzentration und die Schichtung des Ladezustandes durch (Über-) Ladung vermindert oder ihr weiteres Ansteigen vermieden werden kann, ist es sinnvoll die Ladespannung und/oder die Ladedauer zu erhöhen, wenn die ersten und zweiten Kennzahlen KS oder KL ansteigen. Im Falle eines Kraftfahrzeuges ist dies durch Regelung der Generatorspannung möglich.
   1d) Der Wert der ersten und zweiten Kennzahl KS oder KL kann verwendet werden, um einen Vorgang zur Durchmischung des Elektrolyten zu regeln. Dies kann z. B. durch eine in die Speicherbatterie eingebaute Pumpe geschehen, die die Schichtung der Elektrolytkonzentration abbaut. Damit wird auch der Abbau der Ladezustandsschichtung erleichtert.
   1e) Der wässrige Elektrolyt eines Bleiakkumulators beginnt bei tiefen Temperaturen zu erstarren. Der Gefrierpunkt hängt von der örtlichen Konzentration ab. Ist diese inhomogen über die Bauhöhe, wie bei der Schichtung der Elektrolytkonzentration, so setzt die Erstarrung im oberen Zellbereich früher ein als bei homogener Konzentration. Der Wert der ersten Kennzahl KS kann verwendet werden, um dieses Risiko anzuzeigen und zu quantifizieren.
2) Die erhaltenen ersten und zweiten Kennzahlen KS und KL können auch für Vorhersagen des Verhaltens des Energiespeichers, insbesondere zur Vorhersage der Speicherfähigkeit, des Ladezustands, des Spannungsverhaltens bei Belastung mit Strömen, des Spannungsverhaltens im lastfreien Zustand (innere Umladung) oder des Verschleißgrades genutzt werden. Dabei kann auf bekannte Verfahren zurückgegriffen werden, die mit Hilfe der ersten und zweiten Kennzahlen KS und KL nunmehr um eine Maßzahl für das Ausmaß der Schichtung erweitert werden können.
   2a) Die Anwendung von Verfahren, welche nur bei homogener Säuredichte zutreffende Ergebnisse liefern, kann in Abhängigkeit von den Werten der erhaltenden Kennzahlen KS, KL, KW unterdrückt werden. So kann verhindert werden, dass ein Verfahren, welches den Ladezustand einer Speicherbatterie aus der Ruhespannung ableitet, den Ladezustand bei vorliegender Elektrolytschichtung aus der vom unteren Elektrodenbereich mit hoher Elektrolytdichte dominierten Spannungswerten ableitet und fälschlich überschätzt.
   2b) Verfahren, welche bei homogener Elektrolytdichte zutreffende Ergebnisse liefern, können in Abhängigkeit von den Werten der erhaltenen Kennzahlen KS, KL, KW korrigiert werden. So kann ein Verfahren, welches den Ladezustand SOC einer Speicherbatterie aus der Ruhespannung U₀₀ ableitet z. B. durch Berücksichtigung der ersten Kennzahl KS erweitert werden. Dazu kann z. B. der vom unteren Elektrodenbereich mit hoher Elektrolytdichte dominierte Spannungswert als Eingangswert des Verfahrens umso stärker abgesenkt werden, je größer der die Elektrolytschichtung kennzeichnende Wert der ersten Kennzahl KS ist.
   2c) Die Anwendung von Verfahren, welche nur bei nicht erstarrtem Elektrolyten zutreffende Ergebnisse liefern, kann in Abhängigkeit von den Werten der erhaltenden Kennzahlen KS, KL, KW unterdrückt werden. So kann verhindert werden, dass ein Verfahren, welches den Ladezustand SOC einer Speicherbatterie aus der Ruhespannung Uₒₒ ableitet z. B. den Ladezustand SOC bei vorliegender Elektrolytschichtung und eingetretener Erstarrung bei tiefer Temperatur T aus der von der flüssigen Elektrolytphase mit hoher Elektrolytdichte dominierten Spannungswerte ableitet und fälschlich überschätzt.
   2d) In Abhängigkeit der erhaltenen Kennzahlen KS, KL, KW kann zwischen verschiedenen Verfahren umgeschaltet werden. So ist bei einem Bleiakkumulator die speicherbare Ladungsmenge im Allgemeinen durch die Menge und die Konzentration des Elektrolyten bestimmt, weil die ebenfalls an den elektrochemischen Vorgängen beteiligten aktiven Materialien der positiven und negativen Elektroden im Allgemeinen im Überschuss vorliegen. Dies trifft aber nur bei homogener Verteilung des Elektrolyten zu. Bei vorliegender Säureschichtung können unterschiedlich begrenzende Mechanismen wirken, insbesondere können im unteren Bereich die verfügbaren aktiven Elektrodenmaterialien begrenzen. Dieser Effekt wird noch verstärkt, wenn darüber hinaus noch Ladezustandsschichtung vorliegt.
3) Weiterhin kann die erste Kennzahl KS zur Vorhersage der beschleunigten Änderung der Ruhespannung in Folge innerer Umladung verwendet werden, wie in den Figuren 6 und 7 gezeigt ist.
4) Weiterhin kann die Zeitdauer eines Zustandes mit hoher erster Kennzahl KS und zweiter Kennzahl KL als Maß für die nicht mehr umkehrbare Sulfatation und als Eingangsgröße für die Bestimmung von irreversiblen Kapazitätsverlust verwendet werden.
   4a) Wenn eine irreversible Schädigung angenommen wird, kann auch ein Signal mit der Aufforderung zur Wartung oder zum Austausch der Speicherbatterie gesetzt werden.

Mit dem Verfahren werden somit verschiedene Betriebsarten erkannt und ausgewertet:
a) Es werden Arten von Zyklen, Betrieb und Batterie-Zuständen erkannt, welche den Aufbau von Elektrolytschichtung begünstigen. Dabei wird eine den Grad der Elektrolytschichtung beschreibende erste Kennzahl KS bestimmt und es kann die Minderung der Speicherfähigkeit durch Elektrolytschichtung Qv(KS) abgeschätzt werden. In dieser Zeit kann zudem die mögliche Verfälschung der aus der Ruhespannung Uₒₒ abgeleiteten Bestimmung eines Ladezustandswertes SOC, der aus der Ruhespannung Uₒₒ abgeleiteten Spannung unter Last, aus der Ruhespannung Uₒₒ abgeleitete Parameter, wie z. B. Innenwiderstand etc., berücksichtigt werden.
b) Es können Arten des Betriebes und Batterie-Zustände erkannt werden, in denen eine ggf. vorliegende Elektrolytschichtung über die Bauhöhe wieder abgebaut und eine Ladezustandsschichtung (Sulfatschichtung) über die Bauhöhe der Elektroden umgewandelt wird. Hierbei wird eine den Grad der Ladezustandsschichtung beschreibende zweite Kennzahl KL bestimmt. In dieser Zeit kann auch eine Abschätzung der Minderung und danach ggf. des Verschwindens der Verfälschung der aus der Ruhespannung U₀₀ abgeleiteten Bestimmung eines Ladezustandswertes SOC erfolgen. Dabei bleibt aber noch eine Veränderung der Eigenschaften und des Verhaltens der Speicherbatterie, wie z. B. eine Minderung der Speicherfähigkeit durch Ladezustandsschichtung Qv(KL) bestehen.
c) Es können Betriebsarten, die eine ggf. vorher bestehende Elektrolyt- bzw. Sulfatschichtung wieder aufheben, erkannt werden, wie z. B. eine starke Überladung. In dieser Zeit kann der Abbau der ersten und zweiten Kennzahlen KS und KL sowie der durch Elektrolytschichtung Qv(KS) bzw. Ladezustandsschichtung Qv(KL) verursachte Rückgang der Speicherfähigkeit abgeschätzt werden.
d) Die Information über das Ausmaß der Elektrolytschichtung in der Säure S und der Schichtung im Ladezustand der Elektroden kann zur Bestimmung der aktuellen Speicherfähigkeit CSC, zur Vorhersage der aktuell entnehmbaren Ladungsmenge, zur Vorhersage des Spannungsverhaltens bei Lastwechsel und zur Abschätzung irreversibler Alterungsvorgänge, z. B. Sulfatierung etc. verwendet werden.

Das Verfahren beruht auf folgenden Zusammenhängen des Verhaltens einer Speicherbatterie:
1. Eine Elektrolytschichtung entsteht bei der Ladung, wenn in einem Zeitintervall Δt eine größere Netto-Ladungsmenge ΔQ eingeladen wird.
   Die Schichtung im Elektrolyten wird erkannt und mit einer ersten Kennzahl KS bewertet. Für den ungeschichteten Neuzustand wird die erste Kennzahl KS im allgemeinen auf den Wert Null gesetzt.
   Das Ausmaß der Elektrolytschichtung überschreitet einen Maximalwert KSₘₐₓ nicht.
   Der Anstieg der Elektrolytschichtung ΔKS wächst mit der Ladungsdurchsatzrate ΔQ/Δt, d. h. mit dem mittleren Strom, wobei ein gewisser Maximalwert des Anstiegs der Schichtung ΔKS pro Zeitschritt Δt nicht überschritten wird.
   Sehr kleine Ladungsdurchsatzraten ΔQ/Δt führen dagegen zu keiner Verstärkung der Schichtung.
   Der Anstieg ΔKS der Elektrolytschichtung wächst mit der absoluten Ladungsmenge ΔQ, wobei aber unter Umständen ein gewisser Maximalwert des Anstiegs der Elektrolytschichtung ΔKS pro Zeiteinheit Δt nicht überschritten wird.
   Sehr kleine Ladungsmengen ΔQ führen dagegen zu keiner Verstärkung der Schichtung.
2. Der Zeitschritt Δt für die Glättung der Ladungsdurchsatzrate ΔQ/Δt und des Ladungsdurchsatzes ΔQ liegt in der Größenordnung der typischen Zeitkonstanten für den Ausgleich von Elektrolytdichte senkrecht zu den Elektroden. Bei hohen Temperaturen liegt der Zeitschritt Δt z. B. bei etwa einer Minute. Bei sehr tiefen Temperaturen bei etwa zehn Minuten.
3. Bei niedrigem Ladezustand, d. h. niedriger Elektrolytdichte im Plattenzwischenraum, ist eine Ladung mit einer höheren Ladungsdurchsatzrate Δt technisch leichter möglich. Auch die zugeführte Ladungsmenge ΔQ kann höher sein. Beides begünstigt die Ausbildung von Schichtung und wird bereits durch Bestimmung des Ladestroms berücksichtigt.
4. Zusätzlich kann Elektrolytschichtung auch entstehen, wenn dichte Säure aus dem Zellenbereich oberhalb der Elektroden durch den Plattenblock der Speicherbatterie nach unten fällt, ohne dort verbraucht zu werden. Dies tritt aber, ausgehend von einem Zustand mit niedriger ersten Kennzahl KS, nur einmal ein, und zwar wenn erstmalig bei relativ hohem anfänglichen Ladezustandswert SOC mit mindestens mittlerem Strom (z. B. mehr als dem 10-stündigen Strom i₁₀) soviel Ladung ΔQ entladen wird (z. B. mehr als ca. 10% der Kapazität), dass die Überschichtung mit dichterer Säure instabil wird und nach unten durchsackt. Wenn dagegen mit kleinerem Strom entladen wird, so wird die Säure auf ihrem Weg nach unten verbraucht, ohne dass sich die Schichtung verstärkt.
   Mögliche Kriterien für den Fall der Zunahme der ersten Kennzahl KS bei Entladung sind:
   (i) die erste Kennzahl KS hat bezogen auf Ihren Maximalwert KSₘₐₓ einen kleinen Wert;
   (ii) der Ladezustand SOC fällt aktuell unter den kleinen Ladezustandswert SOCₘᵢₙ, der seit dem letzten Erreichen
      a) der annähernden Volladung oder
      b) eines bezogen auf den Maximalwert KSₘₐₓ der ersten Kennzahl bezogenen kleineren Wertes der ersten Kennzahl angenommen wurde.
5. Bei tiefen Temperaturen ist die Stromverteilung über die Porentiefe homogener und die Viskosität der Säure ist höher, so dass Schichtung der Elektrolytkonzentration dort weniger leicht auftritt bzw. weniger stark verstärkt wird. Deshalb sind die Funktionen ΔKS=f(ΔQ/t), ΔKS=f(ΔQ), ΔKL=f(ΔQ/t). ΔKL=f(ΔQ) etc. vorzugsweise derart temperaturabhängig, dass bei niedrigen Temperaturen geringere Veränderungen erfolgen.
6. Die Schichtung im Elektrolyten wird in der Regel durch Entladung oder durch (stromlose) Ruhezeiten abgebaut. Bei Entladung erfolgt der Abbau der höheren Konzentration im unteren Bereich, wobei die Konzentration dort der Konzentration im oberen Bereich angeglichen wird. In den Ruhezeiten wird die höhere Konzentration im unteren Bereich bei gleichzeitiger Erhöhung im oberen Bereich abgebaut, wodurch ebenfalls eine Angleichung erfolgt. In beiden Fällen wird eine Schichtung im Ladezustand aufgebaut, die durch die zweite Kennzahl KL beschrieben wird. Der Wert der zweiten Kennzahl KL wird vorzugsweise auf einen Maximalwert KLₘₐₓ begrenzt. Die Schichtung im Ladezustand KL kann jedoch nicht unter den Minimalwert KLₘᵢₙ für eine neuwertige Speicherbatterie fallen, der vorzugsweise KLₘᵢₙ = 0 beträgt.
7. Die Schichtung im Elektrolyten wird ebenfalls durch Überladung mit Gasung abgebaut. Auch hier kann die durch den die erste Kennzahl KS beschriebene Schichtung nicht unter den Minimalwert KSₘᵢₙ für eine neuwertige Speicherbatterie, vorzugsweise KSₘᵢₙ=0 fallen.
8. Sofern die Schichtung im Elektrolyten durch Überladung mit Gasung den Minimalwert KSₘᵢₙ für eine neuwertige Speicherbatterie zumindest annäherungsweise wieder erreicht hat, so kann auch die mit der zweiten Kennzahl KL beschriebene Schichtung im Ladezustand wieder abgebaut werden. Die Schichtung und der Wert der die Schichtung beschreibenden zweiten Kennzahl KL kann jedoch nicht unter den Minimalwert KLₘᵢₙ für eine neuwertige Speicherbatterie, vorzugsweise KLₘᵢₙ=0 fallen.
   Da Gasung auf Elektrolyse zurückzuführen und diese mit Wasserverlust verbunden ist, kann optional eine weitere den Wasserverlust beschreibende Kennzahl KW eingeführt werden. Diese kann von einem festgelegten Minimalwert KWₘᵢₙ für eine neuwertige Speicherbatterie, vorzugsweise KWₘᵢₙ=0, ausgehend aber nur anwachsen und nicht wieder vermindert werden, es sei denn es erfolgt eine Wartung durch Nachfüllen von Wasser. Die dritte Kennzahl KW ist eine den Verschleiß der Speicherbatterie charakterisierende Größe.

## Patentansprüche

1. Verfahren zur Bestimmung mindestens einer Kenngröße für den Zustand einer elektrochemischen Speicherbatterie mit den Schritten:
a) Bestimmen des Ladungsdurchsatzes (ΔQ) der Speicherbatterie pro Zeitschritt (Δt);
**gekennzeichnet durch**
b) Ermitteln einer ersten Kennzahl (KS) zur Beschreibung der Schichtung der Elektrolytkonzentration in der Speicherbatterie ausgehend von einem definierten Anfangswert (KSₒ) der ersten Kennzahl (KS) für eine neuwertige Speicherbatterie und einer zweiten Kennzahl (KL) zur Beschreibung der Schichtung des Ladezustands (SOC) in der Speicherbatterie ausgehend von einem definierten Anfangswert (KL₀) der zweiten Kennzahl (KL) für eine neuwertige Speicherbatterie im Betrieb der Speicherbatterie, wobei
c) für jeden Zeitschritt (Δt) aus dem aktuellen Zustand der Speicherbatterie, der **durch** den Ladezustand der Elektroden, die Elektrolytkonzentration in der Speicherbatterie und die erste und zweite Kennzahl (KS, KL) **gekennzeichnet** ist, die erste Kennzahl (KS) und die zweite Kennzahl (KL) in Abhängigkeit von dem Ladungsdurchsatz (ΔQ) angepasst wird und mindestens eine Kenngröße aus der ersten und zweiten Kennzahl (KS, KL) bestimmt wird.

2. Verfahren nach Anspruch 1, **dadurch gekennzeichnet, dass** mindestens zwei der folgenden Betriebsphasen bei der Anpassung der ersten und zweiten Kennzahl (KS, KL) unterschieden werden:
a) STROMLOS, wenn der Betrag des Ladungsdurchsatzes (ΔQ) pro Zeitschritt (Δt) kleiner als ein Schwellwert ((ΔQ/Δt)ₘᵢₙ) ist;
b) ENTLADUNG, wenn der Ladungsdurchsatz (ΔQ) pro Zeitschritt (Δt) negativ und betragsmäßig größer als der Schwellwert ((ΔQ/Δt)ₘᵢₙ) ist;
c) LADUNG, wenn der Ladungsdurchsatz (ΔQ) pro Zeitschritt (Δt) positiv und betragsmäßig größer als der Schwellwert ((ΔQ/Δt)ₘᵢₙ) ist und keine ÜBERLADUNG vorliegt;
d) ÜBERLADUNG, wenn der Ladungsdurchsatz (ΔQ) pro Zeitschritt (Δt) positiv und betragsmäßig größer als der Schwellwert ((ΔQ/Δt)ₘᵢₙ) ist und gleichzeitig die erste Kennzahl (KS) bezogen auf den Wertebereich in der Nähe des Anfangswertes (KS₀) liegt, oder wenn aus dem Ladungsdurchsatz (ΔQ) und dem Ladezustand (SOC) der Speicherbatterie eine Gasentwicklung erkannt wird, die einen definierten Gasungs-Schwellwert überschreitet.

3. Verfahren nach Anspruch 2, **dadurch gekennzeichnet, dass** der Schwellwert (ΔQₘᵢₙ) kleiner als der 20-stündige Strom (I₂₀) der Speicherbatterie ist.

4. Verfahren nach Anspruch 2, **dadurch gekennzeichnet, dass** der Schwellwert (ΔQₘᵢₙ) kleiner als der 100-stündige Strom (I₁₀₀) der Speicherbatterie ist.

5. Verfahren nach einem der Ansprüche 2 bis 4, **dadurch gekennzeichnet, dass** im Betriebszustand LADUNG die erste Kennzahl (KS) erhöht wird.

6. Verfahren nach einem der Ansprüche 2 bis 5, **dadurch gekennzeichnet, dass** im Betriebszustand LADUNG die zweite Kennzahl (KL) erhöht wird, wenn
a) die erste Kennzahl (KS) bezogen auf ihren möglichen Wertebereich nicht nahe dem Anfangswert (KS₀) ist und
b) die Summe des Wertes für den Ladezustand (SOC) und der zweiten Kennzahl (KL) bezogen auf den möglichen Wertebereich einen nicht zu hohen Wert aufweist.

7. Verfahren nach einem der Ansprüche 2 bis 6, **dadurch gekennzeichnet, dass** im Betriebszustand LADUNG die zweite Kennzahl (KL) erniedrigt wird, wenn
a) die erste Kennzahl (KS) bezogen auf ihren Wertebereich nicht nahe dem Anfangswert (KS₀) ist und
b) die Summe des Wertes für den Ladezustand (SOC) und der zweiten Kennzahl (KL) bezogen auf Ihren Wertebereich einen hohen Wert aufweist.

8. Verfahren nach einem der Ansprüche 2 bis 7, **dadurch gekennzeichnet, dass** im Betriebszustand ÜBERLADUNG die erste Kennzahl (KS) vermindert wird.

9. Verfahren nach einem der Ansprüche 2 bis 8, **dadurch gekennzeichnet, dass** im Betriebszustand ÜBERLADUNG die zweite Kennzahl (KL) vermindert wird, wenn der Wert der ersten Kennzahl (KS) im Bereich des Anfangswertes (KS₀) ist.

10. Verfahren nach einem der Ansprüche 2 bis 9, **dadurch gekennzeichnet, dass** im Betriebszustand ENTLADUNG die zweite Kennzahl (KL) erhöht wird, wenn die erste Kennzahl (KS) bezogen auf ihren Wertebereich einen hohen Wert aufweist.

11. Verfahren nach einem der Ansprüche 2 bis 10, **dadurch gekennzeichnet, dass** im Betriebszustand ENTLADUNG die erste Kennzahl (KS) erhöht wird, wenn
a) die zweite Kennzahl (KL) bezogen auf ihren Wertebereich nicht nahe dem Anfangswert (KL₀) ist und
b) der Wert des Ladezustandes (SOC) vermindert um den Wert der zweiten Kennzahl (KL) bezogen auf den Wertebereich klein ist.

12. Verfahren nach einem der Ansprüche 2 bis 11, **dadurch gekennzeichnet, dass** im Betriebszustand ENTLADUNG die erste Kennzahl (KS) erniedrigt wird, wenn
a) die zweite Kennzahl (KL) bezogen auf ihren Wertebereich einen erheblichen Wert aufweist, und
b) der Wert des Ladezustandes (SOC) vermindert um den Wert der zweiten Kennzahl (KL) bezogen auf den Wertebereich einen Mindestwertebereich überschreitet und nicht zu klein ist.

13. Verfahren nach einem der Ansprüche 2 bis 12, **dadurch gekennzeichnet, dass** im Betriebszustand STROMLOS die erste Kennzahl (KS) vermindert und die zweite Kennzahl (KL) erhöht wird.

14. Verfahren nach einem der Ansprüche 2 bis 13, **dadurch gekennzeichnet, dass** im Betriebszustand ENTLADUNG die erste Kennzahl (KS) erhöht wird, wenn der aktuelle Wert für den Ladezustand (SOC) niedriger als der bisher niedrigste Wert für den Ladezustand (SOC) seit dem letzten Erreichen
a) eines Zustandes der weitgehenden Volladung oder
b) eines Zustandes ist, in dem die erste Kennzahl (KS) bezogen auf den Wertebereich nahe dem Anfangswert (KS₀) ist.

15. Verfahren nach einem der Ansprüche 2 bis 14, **dadurch gekennzeichnet, dass** im Betriebszustand ENTLADUNG die erste Kennzahl (KS) erhöht wird, wenn die erste Kennzahl (KS) bezogen auf den Wertebereich nahe dem Anfangswert (KS₀) ist.

16. Verfahren nach einem der vorhergehenden Ansprüche, **dadurch gekennzeichnet, dass** die Erhöhung (ΔKS) der ersten Kennzahl (KS) für jeden Zeitschritt (Δt), in dem der Betriebszustand LADUNG erkannt wurde, proportional oder überproportional mit dem Ladungsdurchsatz (ΔQ) in diesem Zeitschritt (Δt) ist.

17. Verfahren nach einem der vorhergehenden Ansprüche, **dadurch gekennzeichnet, dass** im Betriebszustand LADUNG die Erhöhung (ΔKS) der ersten Kennzahl (KS) für den Zeitschritt (Δt) umso kleiner ist, je höher der Wert der Kennzahl (KS) ist.

18. Verfahren nach einem der vorhergehenden Ansprüche, **dadurch gekennzeichnet, dass** der Zeitschritt (At) maximal in der Größenordnung einer für den Speicherbatterietyp charakteristischen Zeitkonstanten für den Ausgleich von Elektrolytdichteverteilungen senkrecht zu den Elektroden liegt.

19. Verfahren nach einem der vorhergehenden Ansprüche, **dadurch gekennzeichnet, dass** der Zeitschritt (At) in einem Bereich von 1 sec bis 30 min liegt.

20. Verfahren nach einem der vorhergehenden Ansprüche, **dadurch gekennzeichnet, dass** während der jeweiligen Zeitschritte (Δt) der Strom (I) der Speicherbatterie weitgehend konstant ist.

21. Verfahren nach einem der vorhergehenden Ansprüche, **gekennzeichnet durch** Festlegen eines unteren Minimalwertes und/oder eines oberen Maximalwertes für die erste Kennzahl (KS) und/oder die zweite Kennzahl (KL) und Beschränken der Werte für die Kennzahlen (KS, KL) auf die jeweils festgelegten Minimal- und/oder Maximalwerte.

22. Verfahren nach Anspruch 21, **dadurch gekennzeichnet, dass** der Minimalwert der ersten Kennzahl (KS) der definierte Anfangswert (KS₀) für eine neuwertige Speicherbatterie ist und vorzugsweise Null beträgt.

23. Verfahren nach Anspruch 21 oder 22, **dadurch gekennzeichnet, dass** der Minimalwert der zweiten Kennzahl (KL) der definierte Anfangswert (KL₀) für eine neuwertige Speicherbatterie ist und vorzugsweise Null beträgt.

24. Verfahren nach einem der Ansprüche 21 bis 23, **dadurch gekennzeichnet, dass** der Maximalwert für die erste Kennzahl (KS) eine Kenngröße für die Speicherbatterie bei einer maximal ausgeprägten Schichtung der Elektrolytkonzentration ist.

25. Verfahren nach einem der Ansprüche 21 bis 24, **dadurch gekennzeichnet, dass** der Maximalwert für die zweite Kennzahl (KL) eine Kenngröße für die Speicherbatterie bei einer maximal ausgeprägten Schichtung des Ladezustandes der Elektroden ist.

26. Verfahren nach einem der vorhergehenden Ansprüche, **gekennzeichnet durch** Berechnung einer Kennlinie der Ruhespannung (U₀₀) über den Ladungsdurchsatz (ΔQ) aus der ersten und/oder zweiten Kennzahl (KS, KL) zur Vorhersage des Zustandes, des Verhaltens oder der Leistungsfähigkeit des Energiespeichers, insbesondere zur Vorhersage der entladbaren Ladungsmenge, der Spannungsänderung bei einer Änderung der elektrischen Last oder der absoluten Spannungslage bei einer angenommenen elektrischen Last.

27. Verfahren nach einem der vorhergehenden Ansprüche, **gekennzeichnet durch** Vorhersage des Zustandes, des Verhaltens oder der Leistungsfähigkeit des Energiespeichers, insbesondere zur Vorhersage der Speicherfähigkeit, des Ladezustands, der entladbaren Ladungsmenge, des Spannungsverhaltens bei Belastung mit Strömen, des Spannungsverhaltens im lastfreien Zustand, des Verschleißgrades, der Spannungsänderung bei einer Änderung der elektrischen Last oder der absoluten Spannungslage bei einer angenommenen elektrischen Last unter Nutzung eines funktionalen Zusammenhanges unter Berücksichtigung des Wertes der ersten Kennzahl (KS) und der zweiten Kennzahl (KL).

28. Verfahren nach einem der vorhergehenden Ansprüche, **gekennzeichnet durch** Vorhersagen der Änderung der Ruhespannung (U₀₀) als Funktion der Zeit (t) aufgrund innerer Umladungsprozesse zwischen Bereichen der Speicherbatterie mit unterschiedlichen Elektrolytkonzentrationen mit einem vorgegebenen oder erlernten, vorzugsweise temperaturabhängigen Zusammenhang der Ruhespannung (U₀₀), der ersten Kennzahl (KS) und der zweiten Kennzahl (KL).

29. Verfahren nach einem der vorhergehenden Ansprüche, **dadurch gekennzeichnet, dass** im Betriebszustand ÜBERLADUNG eine dritte Kennzahl (KW) erhöht wird, wobei die dritte Kennzahl (KW) ausgehend von einem Anfangswert (KWₘᵢₙ), vorzugsweise KWₘᵢₙ gleich Null, nur ansteigen kann und nie vermindert wird, und wobei die dritte Kennzahl (KW) als ein Maß für den Verschleiß der Speicherbatterie dient.

30. Verfahren nach einem der vorhergehenden Ansprüche, **dadurch gekennzeichnet, dass** mindestens eine der ersten, zweiten und dritten Kennzahlen (KS, KL, KW) angezeigt wird, beispielsweise als Wartungshinweis oder Austauschhinweis oder zur Auslösung einer Maßnahme genutzt wird, wie beispielsweise zur Regelung einer Ladeeinrichtung, Pumpe oder Temperiereinrichtung.

31. Verfahren nach einem der vorhergehenden Ansprüche, **dadurch gekennzeichnet, dass** mindestens eine der erhaltenen Kennzahlen (KS, KL, KW) mit einem anderen Verfahren zur Bestimmung oder Vorhersage des Zustandes und/oder des Verhaltens einer Speicherbatterie, vorzugsweise zur Vorhersage der Speicherfähigkeit, des Ladezustands, des Spannungsverhaltens bei Belastung mit Strömen oder des Verschleißgrades verknüpft wird.

32. Verfahren nach Anspruch 31, **dadurch gekennzeichnet, dass** bei der Verknüpfung mit einem anderen Verfahren auch Ergebnisgrößen dieses anderen Verfahrens in die Bestimmung der Kennzahlen (KS, KL, KW) einfließen.

33. Überwachungseinrichtung für eine Speicherbatterie mit einer Einheit zur Bestimmung des Ladungsdurchsatzes (ΔQ) der Speicherbatterie und mit Auswertemitteln, **dadurch gekennzeichnet, dass** die Auswertemittel zur Durchführung des Verfahrens nach einem der vorhergehenden Ansprüche vorzugsweise durch Programmierung einer Mikroprozessoreinheit ausgebildet sind.

## Claims

1. A method for determination of at least one characteristic variable for the state of an electrochemical energy storage battery, having the following steps:
a) determination of the charge throughput (ΔQ) of the energy storage battery per time step (Δt);
comprising
b) determination of a first characteristic figure (KS) in order to describe the stratification of the electrolyte concentration in the energy storage battery on the basis of a defined initial state (KS₀) for an as-new energy storage battery, and of a second characteristic figure (KL) in order to describe the stratification of the state of charge (SOC) in the energy storage battery on the basis of a defined initial value (KL₀) for an as-new energy storage battery during operation of the energy storage battery, in which
c) in each time step (Δt), the first characteristic figure (KS) and the second characteristic figure (KL) are adapted as a function of the charge throughput (ΔQ) from the instantaneous state of the energy storage battery, which is **characterized by** the state of charge of the electrodes, the electrolyte concentration in the energy storage battery and the first and second characteristic figures (KS, KL), and at least one characteristic variable is determined from the first and the second characteristic figure (KS, KL).

2. The method as claimed in claim 1, wherein a distinction is drawn between at least two of the following operating phases for adaptation of the first and the second characteristic figure (KS, KL);
a) ZERO-CURRENT, when the magnitude of the charge throughput (ΔQ) per time step (Δt) is less than a threshold value ((ΔQ/Δt)ₘᵢₙ);
b) DISCHARGING, when the charge throughput (ΔQ) per time step (Δt) is negative and whose magnitude is greater than the threshold value ((ΔQ/Δt )ₘᵢₙ) ;
c) CHARGING, when the charge throughput (ΔQ) per time step (Δt) is positive and its magnitude is greater than the threshold value ((ΔQ/Δt)ₘᵢₙ) and OVERCHARGING is not occurring;
d) OVERCHARGING, when the charge throughput (ΔQ) per time step (Δt) is positive and its magnitude is greater than the threshold value ((ΔQ/Δt)ₘᵢₙ) and, at the same time, the first characteristic figure (KS) is in the vicinity of the initial value (KS_{Q}) with respect to the value range, or when gas development which exceeds a defined gassing threshold value is identified from the charge throughput (ΔQ) and the state of charge (SOC) of the energy storage battery.

3. The method as claimed in claim 2, wherein the threshold value (ΔQₘᵢₙ) is less than the 20-hour current (I₂₀) of the energy storage battery.

4. The method as claimed in claim 2, wherein the threshold value (ΔQₘᵢₙ) is less than the 100-hour current (I₁₀₀) of the energy storage battery.

5. The method as claimed in one of claims 2 to 4, wherein the first characteristic figure (KS) is increased in the CHARGING operating state.

6. The method as claimed in one of claims 2 to 5, wherein the second characteristic figure (KL) is increased in the CHARGING operating state, when
a) the first characteristic figure (KS) is not close to the initial value (KS₀) with respect to its possible value range, and
b) the sum of the value for the state of charge (SOC) and of the second characteristic figure (KL) has a value which is not excessively high with respect to the possible value range.

7. The method as claimed in one of claims 2 to 6, wherein the second characteristic figure (KL) is reduced in the CHARGING operating state, when
a) the first characteristic figure (KS) is not close to the initial value (KS₀) with respect to its value range, and
b) the sum of the value for the state of charge (SOC) and of the second characteristic figure (KL) has a high value with respect to its value range.

8. The method as claimed in one of claims 2 to 7, wherein the first characteristic figure (KS) is reduced in the OVERCHARGING operating state.

9. The method as claimed in one of claims 2 to 8, wherein the second characteristic figure (KL) is reduced in the OVERCHARGING operating state when the value of the first characteristic figure (KS) is in the region of the initial value (KS₀).

10. The method as claimed in one of claims 2 to 9, wherein the second characteristic figure (KL) is increased in the DISCHARGING operating state when the first characteristic figure (KS) has a high value with respect to its value range.

11. The method as claimed in one of claims 2 to 10, wherein the first characteristic figure (KS) is increased in the DISCHARGING operating state, when
a) the second characteristic figure (KL) is not close to the initial value (KL₀) with respect to its value range, and
b) the value of the state of charge (SOC) minus the value of the second characteristic figure (KL) is small with respect to the value range.

12. The method as claimed in one of claims 2 to 11, wherein the first characteristic figure (KS) is reduced in the DISCHARGING operating state, when
a) the second characteristic figure (KL) has a considerable value with respect to its value range, and
b) the value of the state of charge (SOC) minus the value of the second characteristic figure (KL) exceeds a minimum value range, and is not excessively small, with respect to the value range.

13. The method as claimed in one of claims 2 to 12, wherein the first characteristic figure (KS) is reduced and the second characteristic figure (KL) is increased in the ZERO-CURRENT operating state.

14. The method as claimed in one of claims 2 to 13, wherein the first characteristic figure (KS) is increased in the DISCHARGING operating state when the instantaneous value for the state of charge (SOC) is lower than the previously lowest value for the state of charge (SOC) since the following was last reached:
a) a state of largely complete charging, or
b) a state in which the first characteristic figure (KS) is close to the initial value (KS₀) with respect to the value range.

15. The method as claimed in one of claims 2 to 14, wherein the first characteristic figure (KS) is increased in the DISCHARGING operating state when the first characteristic figure (KS) is close to the initial value (KS₀) with respect to the value range.

16. The method as claimed in one of the preceding claims, wherein the increase (ΔKS) in the first characteristic figure (KS) for each time step (Δt) in which the CHARGING operating state was identified is proportional to or more than proportional to the charge throughput (ΔQ) in this time step (Δt).

17. The method as claimed in one of the preceding claims, wherein the increase (ΔKS) in the first characteristic figure (KS) for the time step (Δt) in the CHARGING operating state decreases the higher the value of the characteristic figure (KS).

18. The method as claimed in one of the preceding claims; wherein the time step (Δt) is, as a maximum, in the same order of magnitude as a time constant, which is characteristic of the type of energy storage battery, for the equalization of the electrolyte density distributions at right angles to the electrodes.

19. The method as claimed in one of the preceding claims, wherein the time step (Δt) is in a range from 1 second to 30 minutes.

20. The method as claimed in one of the preceding claims, wherein the current (I) into or out of the energy storage battery is largely constant during the respective time steps (Δt).

21. The method as claimed in one of the preceding claims, comprising the definition of a lower minimum value and/or of an upper maximum value for the first characteristic figure (KS) and/or the second characteristic figure (KL), and the restriction of the values for the characteristic figures (KS, KL) to the respectively defined minimum and/or maximum values.

22. The method as claimed in claim 21, wherein the minimum value of the first characteristic figure (KS) is the defined initial value (KS₀) for an as-new energy storage battery, and is preferably zero.

23. The method as claimed in claim 21 or 22, wherein the minimum value of the second characteristic figure (KL) is the defined initial value (KL₀) for an as-new energy storage battery, and is preferably zero.

24. The method as claimed in one of claims 21 to 23, wherein the maximum value for the first characteristic figure (KS) is a characteristic variable for the energy storage battery for the maximum stratification of the electrolyte concentration.

25. The method as claimed in one of claims 21 to 24, wherein the maximum value for the second characteristic figure (KL) is a characteristic variable for the energy storage battery for the maximum stratification of the state of charge of the electrodes.

26. The method as claimed in one of the preceding claims, comprising the calculation of a characteristic curve for the rest voltage (U₀₀) plotted against the charge throughput (ΔQ) from the first and/or second characteristic figure (KS, KL) in order to predict the state, the behavior or the performance of the energy store, in particular in order to predict the amount of charge which can be drawn, the voltage change when the electrical load is varied, or the absolute voltage for an assumed electrical load.

27. The method as claimed in one of the preceding claims, comprising the prediction of the state, of the behavior or of the performance of the energy store, in particular in order to predict the storage capability, the state of charge, the amount of charge which can be drawn, the voltage response when loaded with currents, the voltage response on no-load, the degree of wear, the change in voltage for a change in the electrical load, or the absolute voltage for an assumed electrical load using a functional relationship taking into account the value of the first characteristic figure (KS) and of the second characteristic figure (KL).

28. The method as claimed in one of the preceding claims, comprising the prediction of the change in the rest voltage (Uoo) as a function of the time (t) on the basis of internal charge-reversal processes between areas of the energy storage battery with different electrolyte concentrations and with a predetermined or learned, preferably temperature-dependent, relationship between the rest voltage (U₀₀), the first characteristic figure (KS) and the second characteristic figure (KL).

29. The method as claimed in one of the preceding claims, wherein a third characteristic figure (KW) is increased in the OVERCHARGING operating state, in which case the third characteristic figure (KW) can only rise and is never reduced starting from an initial value (KWₘᵢₙ), preferably KWₘᵢₙ equal to zero, and in which case the third characteristic figure (KW) is used as a measure of the wear of the energy storage battery.

30. The method as claimed in one of the preceding claims, wherein at least one of the first, second and third characteristic figures (KS, KL, KW) is indicated, for example as maintenance information or as replacement information, or in order to initiate an action, for example in order to regulate a charging device, a pump or a temperature control device.

31. The method as claimed in one of the preceding claims, wherein at least one of the characteristic figures (KS, KL, KW) obtained is logically linked with another method for determination or prediction of the state and/or of the behavior of an energy storage battery, preferably in order to predict the storage capability, the state of charge, the voltage response when loaded with currents or the degree of wear.

32. The method as claimed in claim 31, wherein the logical link with another method also includes result variables from this other method in the determination of the characteristic figures (KS, KL, KW).

33. A monitoring device for an energy storage battery having a unit for determination of the charge throughput (ΔQ) of the energy storage battery and having evaluation means, wherein the evaluation means are designed to carry out the method as claimed in one of the preceding claims, preferably by programming of a microprocessing unit.

## Revendications

1. Procédé pour la détermination d'au moins une grandeur caractéristique de l'état d'une batterie électrochimique comportant les étapes suivantes :
a) Détermination du débit de charge (ΔQ) de la batterie par palier de temps (Δt) ;
**caractérisé par**
b) la détermination d'un premier indice (KS) pour décrire la stratification de la concentration d'électrolyte dans la batterie à partir d'une valeur de départ définie (KS₀) du premier indice (KS) pour une batterie neuve et d'un deuxième indice (KL) pour décrire de la stratification de l'état de charge (SOC) dans la batterie à partir d'une valeur de départ définie (KL₀) du deuxième indice (KL) pour une batterie neuve lors du fonctionnement de la batterie,
c) le premier indice (KS) et le deuxième indice (KL) étant adaptés en fonction du débit de charge (ΔQ) et au moins une grandeur caractéristique étant déterminée à partir d'un premier indice et d'un deuxième indice (KS, KL) pour chaque palier de temps (Δt) à partir de l'état actuel de la batterie **caractérisé par** l'état de charge des électrodes, la concentration d'électrolyte dans la batterie et le premier indice et le deuxième indice (KS, KL).

2. Procédé selon la revendication 1,
**caractérisé en ce qu'**
on distingue au moins deux des phases de fonctionnement suivantes lors de l'adaptation du premier indice et du deuxième indice (KS, KL) :
a) HORS TENSION, lorsque la valeur du débit de charge (ΔQ) par palier de temps (Δt) est inférieure à une valeur de seuil ((ΔQ/Δt)ₘᵢₙ) ;
b) DECHARGE, lorsque le débit de charge (ΔQ) par palier de temps (Δt) est négatif et, en valeur, supérieur à la valeur de seuil ((ΔQ/Δt)ₘᵢₙ) ;
c) CHARGE, lorsque le débit de charge (ΔQ) par palier de temps (Δt) est positif et, en valeur, supérieur à la valeur de seuil ((ΔQ/Δt)ₘᵢₙ) et lorsqu'il n'y a pas de SURCHARGE ;
d) SURCHARGE, lorsque le débit de charge (ΔQ) par palier de temps (Δt) est positif et, en valeur, supérieur à la valeur de seuil ((ΔQ/At)ₘᵢₙ) et, dans le même temps, le premier indice (KS) est proche de la valeur de départ (KS₀) par rapport au domaine de valeurs, ou lorsqu'on détecte une production de gaz, qui dépasse la valeur de seuil de dégagement de gaz définie, à partir du débit de charge (ΔQ) et de l'état de charge (SOC) de la batterie.

3. Procédé selon la revendication 2,
**caractérisé en ce que**
la valeur de seuil (ΔQₘᵢₙ) est inférieure au courant pendant 20 heures (I₂₀) de la batterie.

4. Procédé selon la revendication 2,
**caractérisé en ce que**
la valeur de seuil (ΔQₘᵢₙ) est inférieure au courant pendant 100 heures (I₁₀₀) de la batterie.

5. Procédé selon l'une quelconque des revendications 2 à 4,
**caractérisé en ce qu'**
on augmente le premier indice (KS) pendant l'état de fonctionnement CHARGE.

6. Procédé selon l'une quelconque des revendications 2 à 5,
**caractérisé en ce qu'**
on augmente le deuxième indice (KL) pendant l'état de fonctionnement CHARGE lorsque
a) le premier indice (KS) n'est pas proche de la valeur de départ (KS₀) par rapport à son domaine de valeurs possible et
b) le total de la valeur de l'état de charge (SOC) et du deuxième indice (KL) n'a pas une valeur trop élevée par rapport au domaine de valeurs possible.

7. Procédé selon l'une quelconque des revendications 2 à 6,
**caractérisé en ce qu'**
on diminue le deuxième indice (KL) pendant l'état de fonctionnement CHARGE lorsque
a) le premier indice (KS) n'est pas proche de la valeur de départ (KS₀) par rapport à son domaine de valeurs, et
b) le total de la valeur de l'état de charge (SOC) et du deuxième indice (KL) a une valeur élevée par rapport à son domaine de valeurs.

8. Procédé selon l'une quelconque des revendications 2 à 7,
**caractérisé en ce qu'**
on diminue le premier indice (KS) pendant l'état de fonctionnement SURCHARGE.

9. Procédé selon l'une quelconque des revendications 2 à 8,
**caractérisé en ce qu'**
on diminue le deuxième indice (KL) pendant l'état de fonctionnement SURCHARGE lorsque la valeur du premier indice (KS) se trouve dans le domaine de la valeur de départ (KS₀).

10. Procédé selon l'une quelconque des revendications 2 à 9,
**caractérisé en ce qu'**
on augmente le deuxième indice (KL) pendant l'état de fonctionnement DECHARGE lorsque le premier indice (KS) a une valeur élevée par rapport à son domaine de valeurs.

11. Procédé selon l'une quelconque des revendications 2 à 10,
**caractérisé en ce qu'**
on augmente le premier indice (KS) pendant l'état de fonctionnement DECHARGE lorsque
a) le deuxième indice (KL) a une valeur de départ (KL₀) éloignée par rapport à son domaine de valeurs et
b) la valeur de l'état de charge (SOC), diminuée de la valeur du deuxième indice (KL), est faible par rapport au domaine de valeurs.

12. Procédé selon l'une quelconque des revendications 2 à 11,
**caractérisé en ce qu'**
on diminue le premier indice (KS) pendant l'état de fonctionnement DECHARGE lorsque
a) le deuxième indice (KL) a une valeur importante par rapport à son domaine de valeurs, et
b) la valeur de l'état de charge (SOC), diminuée du deuxième indice (KL), dépasse un domaine de valeurs minimales par rapport au domaine de valeurs et n'est pas trop faible.

13. Procédé selon l'une quelconque des revendications 2 à 12,
**caractérisé en ce que**
dans l'état de fonctionnement HORS TENSION, on diminue le premier indice (KS) et on augmente le deuxième indice (KL).

14. Procédé selon l'une quelconque des revendications 2 à 13,
**caractérisé en ce que**
dans l'état de fonctionnement DECHARGE, on augmente le premier indice (KS) lorsque la valeur actuelle de l'état de charge (SOC) est plus faible que la valeur, jusqu'ici la plus faible, de l'état de charge (SOC) depuis la dernière fois
a) qu'un état de charge largement pleine a été atteint ou
b) qu'un état, dans lequel le premier indice (KS) est proche de la valeur de départ (KS₀) par rapport au domaine de valeurs, a été atteint.

15. Procédé selon l'une quelconque des revendications 2 à 14,
**caractérisé en ce que**
dans l'état de fonctionnement DECHARGE, on augmente le premier indice (KS) lorsque le premier indice (KS) est proche de la valeur de départ (KS₀) par rapport au domaine de valeurs.

16. Procédé selon l'une quelconque des revendications précédentes,
**caractérisé en ce que**
l'augmentation (ΔKS) du premier indice (KS) de chaque palier de temps (Δt) pendant lequel l'état de fonctionnement CHARGE a été détecté, est proportionnel ou proportionnellement supérieur au débit de charge (ΔQ) pendant ce palier de temps (Δt).

17. Procédé selon l'une quelconque des revendications précédentes,
**caractérisé en ce que**
l'augmentation (ΔKS) du premier indice (KS) de chaque palier de temps (Δt) pendant l'état de fonctionnement CHARGE est d'autant plus petite que la valeur de l'indice (KS) est élevée.

18. Procédé selon l'une quelconque des revendications précédentes,
**caractérisé en ce que**
le palier de temps (Δt), au maximum d'un ordre de grandeur d'une constante de temps, caractéristique du type de batterie, pour la compensation de répartitions de la densité d'électrolyte, est perpendiculaire aux électrodes.

19. Procédé selon l'une quelconque des revendications précédentes;
**caractérisé en ce que**
le palier de temps (Δt) est de l'ordre de 1 sec à 30 min.

20. Procédé selon l'une quelconque des revendications précédentes,
**caractérisé en ce que**
le courant (I) de la batterie est largement constant pendant les paliers de temps (Δt) respectifs.

21. Procédé selon l'une quelconque des revendications précédentes,
**caractérisé par**
la fixation d'une valeur minimale inférieure et/ou d'une valeur maximale supérieure pour le premier indice (KS) et/ou le deuxième indice (KL), et la limitation des valeurs des indices (KS, KL) aux valeurs minimales et/ou maximales fixées respectives.

22. Procédé selon la revendication 21,
**caractérisé en ce que**
la valeur minimale du premier indice (KS) est la valeur de départ définie (KS₀) pour une batterie neuve et, de préférence, égale à zéro.

23. Procédé selon la revendication 21 ou la revendication 22,
**caractérisé en ce que**
la valeur minimale du deuxième indice (KL) est la valeur de départ définie (KL₀) pour une batterie neuve et, de préférence, égale à zéro.

24. Procédé selon l'une quelconque des revendications 21 à 23,
**caractérisé en ce que**
la valeur maximale du premier indice (KS) est une grandeur caractéristique de la batterie avec une stratification maximale marquée de la concentration d'électrolyte.

25. Procédé selon l'une quelconque des revendications 21 à 24,
**caractérisé en ce que**
la valeur maximale du deuxième indice (KL) est une grandeur caractéristique de la batterie avec une stratification maximale marquée de l'état de charge des électrodes.

26. Procédé selon l'une quelconque des revendications précédentes,
**caractérisé par**
le calcul d'une courbe caractéristique de la tension de repos (Uoo) avec le débit de charge (ΔQ) à partir du premier et/ou du deuxième indice (KS, KL) pour prédire l'état, le comportement ou la puissance de l'accumulateur d'énergie, en particulier pour prédire la quantité de charge déchargeable, la modification de la tension en cas de variation de la charge électrique ou la situation de tension absolue avec une charge électrique supposée.

27. Procédé selon l'une quelconque des revendications précédentes,
**caractérisé par**
la prédiction de l'état, du comportement ou de la puissance de l'accumulateur d'énergie, en particulier pour prédire la capacité d'accumulation, l'état de charge, la quantité de charge déchargeable, le comportement de la tension en cas de sollicitation par des courants, le comportement de la tension dans l'état sans charge, le degré d'usure, la modification de la tension en cas de variation de la charge électrique ou la situation de tension absolue avec une charge électrique supposée en utilisant une relation fonctionnelle tenant compte de la valeur du premier indice (KS) et du deuxième indice (KL).

28. Procédé selon l'une quelconque des revendications précédentes,
**caractérisé par**
la prédiction de la modification de la tension de repos (Uoo) en tant que fonction du temps (t) basée sur des processus d'inversion de charge internes entre certaines zones de la batterie ayant des concentrations d'électrolyte différentes avec un rapport prédéfini ou acquis, de préférence dépendant de la température, de la tension de repos (U₀₀), du premier indice (KS) et du deuxième indice (KL).

29. Procédé selon l'une quelconque des revendications précédentes,
**caractérisé en ce que**
dans l'état de fonctionnement SURCHARGE, on augmente un troisième indice (KW), le troisième indice (KW) à partir d'une valeur de départ (KWₘᵢₙ), KWₘᵢₙ étant de préférence égal à zéro, ne pouvant qu'augmenter et jamais diminuer, et le troisième indice (KW) servant de mesure pour l'usure de la batterie.

30. Procédé selon l'une quelconque des revendications précédentes,
**caractérisé en ce que**
l'un des premiers, deuxièmes et troisièmes indices (KS, KL, KW) est affiché, par exemple en tant qu'information de maintenance ou de remplacement ou utilisé pour déclencher une intervention comme, par exemple, le réglage d'un dispositif de charge, d'une pompe ou d'un dispositif de tempérage.

31. Procédé selon l'une quelconque des revendications précédentes,
**caractérisé en ce que**
au moins l'un des indices obtenus (KS, KL, KW) est lié à un autre procédé de détermination ou de prédiction de l'état et/ou du comportement d'une batterie, de préférence pour prédire la capacité d'accumulation, l'état de charge, le comportement de la tension en cas de sollicitation par des courants ou le degré d'usure.

32. Procédé selon la revendication 31,
**caractérisé en ce que**
lors de l'association à un autre procédé, les résultats de cet autre procédé sont inclus dans la détermination des indices (KS, KL, KW).

33. Dispositif de surveillance d'une batterie comportant une unité de détermination du débit de charge (ΔQ) de la batterie et des moyens d'analyse,
**caractérisé en ce que**
les moyens d'analyse sont configurés pour réaliser le procédé selon l'une quelconque des revendications précédentes, de préférence en programmant une unité de microprocesseur.
